(19)

**Europäisches Patentamt**

**European Patent Office**

**Office européen des brevets**

(11)  **EP 4 488 405 A1**

(12)  # EUROPEAN PATENT APPLICATION

(43) Date of publication:
08.01.2025 Bulletin 2025/02

(21) Application number: 24185547.7

(22) Date of filing: 28.06.2024

(51) International Patent Classification (IPC):
*C23C 16/02* (2006.01)    *C23C 16/04* (2006.01)
*C23C 16/32* (2006.01)    *C23C 16/34* (2006.01)
*C23C 16/40* (2006.01)    *C23C 16/455* (2006.01)
*C23C 16/52* (2006.01)    *H01L 21/02* (2006.01)

(52) Cooperative Patent Classification (CPC):
C23C 16/45546; C23C 16/02; C23C 16/04;
C23C 16/045; C23C 16/32; C23C 16/34;
C23C 16/405; C23C 16/45527; C23C 16/45534;
C23C 16/52; H01L 21/0217; H01L 21/02211;
H01L 21/0228

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 30.06.2023 JP 2023108911

(71) Applicant: Kokusai Electric Corp.
Tokyo 1010045 (JP)

(72) Inventors:
• NAGATOMI, Yoshimasa
Toyama-shi, 939-2393 (JP)
• ISOBE, Noriyuki
Toyama-shi, 939-2393 (JP)
• EDA, Akira
Toyama-shi, 939-2393 (JP)
• SUENAGA, Shinjiro
Toyama-shi, 939-2393 (JP)

(74) Representative: Verscht, Thomas Kurt Albert
Josephsburgstrasse 88 A
81673 München (DE)

(54) **SUBSTRATE PROCESSING METHOD, METHOD OF MANUFACTURING SEMICONDUCTOR DEVICE, PROGRAM AND SUBSTRATE PROCESSING APPARATUS**

(57) To suppress an adhesion of a by-product generated by a reaction, there is provided a technique that includes: forming a film on a substrate by performing a cycle a predetermined number of times, wherein the cycle includes: (a) supplying a first gas containing a NH- group to the substrate; (b) supplying a source gas to the substrate; and (c) supplying a reactive gas to the substrate, wherein (a), (b) and (c) are sequentially performed in this order in the cycle, and the film contains an element contained in the source gas and an element contained in the reactive gas.

**EP 4 488 405 A1**

## Description

**[Technical Field]**

The present disclosure relates to a substrate processing method, a method of manufacturing a semiconductor device, a program and a substrate processing apparatus.

**[Related Art]**

According to some related arts, as a part of a manufacturing process of a semiconductor device, a process of forming a film on a substrate may be performed (for example, see Patent Document 1).

[Related Art]

[Patent document]

Patent Document 1: Japanese Patent Laid-Open No. 2008-124184

**[Disclosure]**

**[Technical Problem]**

According to the present disclosure, there is provided a technique capable of suppressing an adhesion of a by-product generated by a reaction.

**[Technical Solution]**

According to an aspect of the present disclosure, there is provided a technique that includes forming a film on a substrate by performing a cycle a predetermined number of times, wherein the cycle includes: (a) supplying a first gas containing a NH- group to the substrate; (b) supplying a source gas to the substrate; and (c) supplying a reactive gas to the substrate, wherein (a), (b) and (c) are sequentially performed in this order in the cycle, and the film contains an element contained in the source gas and an element contained in the reactive gas.

**[Advantageous Effects]**

According to some embodiments of the present disclosure, it is possible to suppress an adhesion of a by-product generated by a reaction.

**[Brief Description of Drawings]**

FIG. 1(a) is a diagram schematically illustrating a vertical cross-section of a vertical type process furnace (also simply referred to as a "process furnace 202") of a substrate processing apparatus preferably used in one or more embodiments of the present disclosure, and FIG. 1(b) is a diagram schematically illustrating a furnace opening lid capable of airtightly closing (or sealing) a lower end opening of a manifold 209 shown in FIG. 1(a).
FIG. 2 is a diagram schematically illustrating a horizontal cross-section, taken along a line A - A shown in FIG. 1(a), of the vertical type process furnace (process furnace 202) of the substrate processing apparatus preferably used in the embodiments of the present disclosure.
FIG. 3 is a block diagram schematically illustrating a configuration of a controller 121 and related components of the substrate processing apparatus preferably used in the embodiments of the present disclosure.
FIG. 4 is a flow chart schematically illustrating a substrate processing flow according to the embodiments of the present disclosure.
FIG. 5 is a diagram schematically illustrating a substrate processing sequence according to the embodiments of the present disclosure.

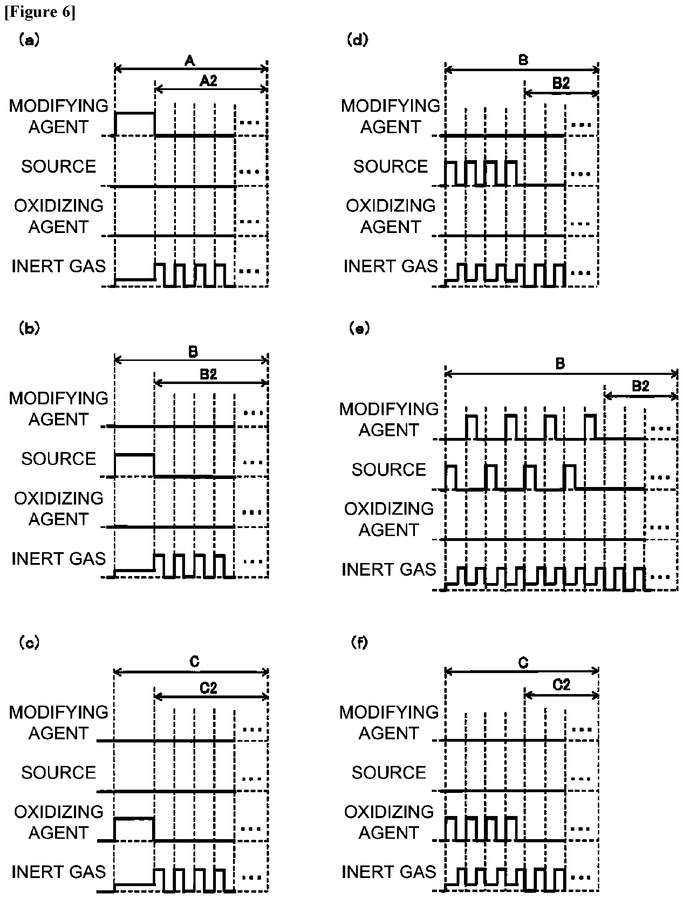

FIG. 6(a) is a diagram schematically illustrating a modifying agent supply sequence according to the embodiments of the present disclosure, FIG. 6(b) is a diagram schematically illustrating a source supply sequence according to the embodiments of the present disclosure, FIG. 6(c) is a diagram schematically illustrating an oxidizing agent supply sequence according to the embodiments of the present disclosure, FIG. 6(d) is a diagram schematically illustrating another source supply sequence according to the embodiments of the present disclosure, FIG. 6(e) is a diagram schematically illustrating still another source supply sequence according to the embodiments of the present disclosure, and FIG. 6(f) is a diagram schematically illustrating another oxidizing agent supply sequence according to the embodiments of the present disclosure.

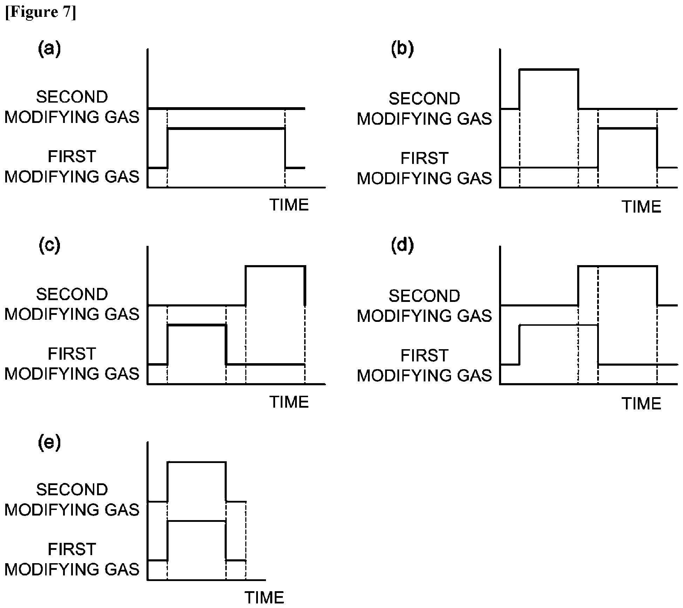

FIG. 7(a) is a diagram schematically illustrating a modifying agent supply sequence according to other embodiments of the present disclosure, FIG. 7(b) is a diagram schematically illustrating another modifying agent supply sequence according to other embodiments of the present disclosure, FIG. 7(c) is a diagram schematically illustrating still another modifying agent supply sequence according to other embodiments of the present disclosure, FIG. 7(d) is a diagram schematically illustrating still another modifying agent supply sequence according to other embodiments of the present disclosure, and FIG. 7(e) is a diagram schematically illustrating still another modifying agent supply sequence according to other embodiments of the present disclosure.

FIG. 8(a) is a diagram schematically illustrating an adsorption and formation of a film in a concave structure in an example of the embodiments of the present disclosure, and FIG. 8B is a diagram schematically illustrating an adsorption and formation of a film in a concave structure in a comparative example.

FIG. 9 is a diagram schematically illustrating the example and the comparative example.

**[Brief Description of Drawings]**

<Embodiments of Present Disclosure>

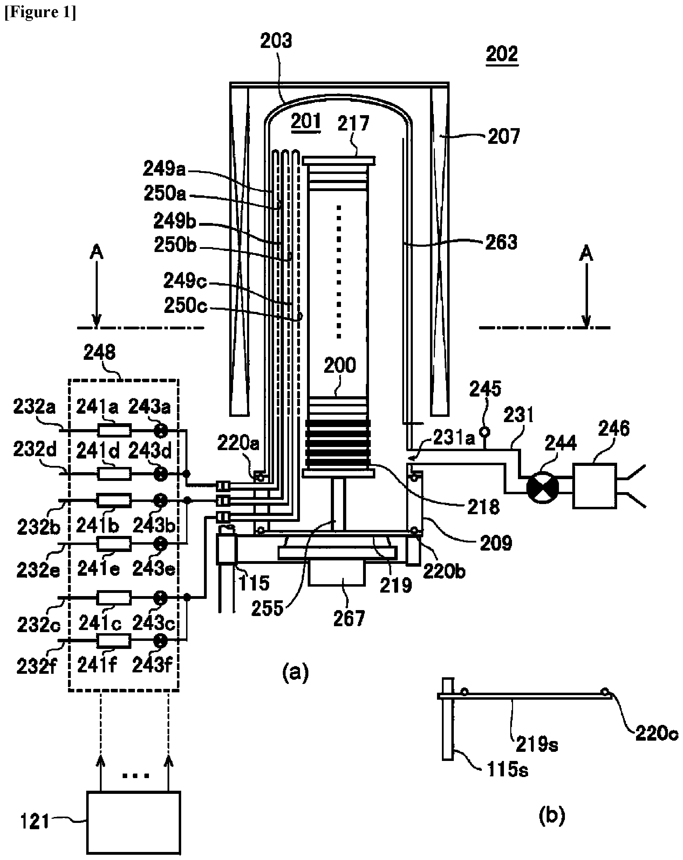

Hereinafter, one or more embodiments (also simply referred to as "embodiments") of the technique of the present disclosure will be described in detail mainly with reference to FIGS. 1A, 1B and FIGS. 2 to 5. The drawings used in the following descriptions are all schematic. For example, a relationship between dimensions of each component and a ratio of each component shown in the drawing may not always match the actual ones. Further, even between the drawings, the relationship between the dimensions of each component and the ratio of each component may not always match.

(1) Configuration of Substrate Processing Apparatus

As shown in FIGS. 1A and 1B, a substrate processing apparatus according to the present embodiments includes a vertical type process furnace (also simply referred to as a "process furnace") 202. The process furnace 202 includes a heater 207 serving as a temperature regulator (which is a temperature adjusting structure or a heating structure). The heater 207 is of a cylindrical shape, and is vertically installed while being supported by a support plate (not shown). The heater 207 also functions as an activator (also referred to as an "exciter") capable of activating (or exciting) a gas by a heat.

A reaction tube 203 is provided in an inner side of the heater 207 to be aligned in a manner concentric with the heater 207. For example, the reaction tube 203 is made of a heat resistant material such as quartz ($SiO_2$) and silicon carbide (SiC). For example, the reaction tube 203 is of a cylindrical shape with a closed upper end and an open lower end. A manifold 209 is provided under the reaction tube 203 to be aligned in a manner concentric with the reaction tube 203. For example, the manifold 209 is made of a metal material such as stainless steel (SUS). For example, the manifold 209 is of a cylindrical shape with open upper and lower ends. An upper end portion of the manifold 209 is engaged with a lower end portion of the reaction tube 203 so as to support the reaction tube 203. An O-ring 220a serving as a seal is provided between the manifold 209 and the reaction tube 203. Similar to the heater 207, the reaction tube 203 is installed vertically. A process vessel (also referred to as a "reaction vessel") is constituted mainly by the reaction tube 203 and the manifold 209. A process chamber 201 is provided in a hollow cylindrical portion of the process vessel. The process chamber 201 is configured to be capable of accommodating a plurality of wafers including a wafer 200 serving as a substrate. Hereinafter, the plurality of wafers including the wafer 200 may also be simply referred to as "wafers 200". The wafer 200 is processed in the process chamber 201.

Nozzles 249a, 249b and 249c are provided in the process chamber 201 so as to penetrate a side wall of the manifold 209. The nozzle 249a serves as a first supplier (which is a first supply structure), the nozzle 249b serves as a second supplier (which is a second supply structure) and the nozzle 249c serves as a third supplier (which is a third supply structure). The nozzles 249a, 249b and 249c may also be referred to as a first nozzle 249a, a second nozzle 249b and a third nozzle 249c, respectively. For example, each of the nozzles 249a, 249b and 249c is made of a heat resistant material such as quartz and silicon carbide (SiC). Gas supply pipes 232a, 232b and 232c are connected to the nozzles 249a, 249b and 249c, respectively. The nozzles 249a, 249b and 249c are different nozzles. The nozzles 249a and 249c are provided adjacent to the nozzle 249b such that the nozzle 249b is interposed between the nozzles 249a and 249c.

Mass flow controllers (also simply referred to as "MFCs") 241a, 241b and 241c serving as flow rate controllers (flow rate control structures) and valves 243a, 243b and 243c serving as opening/closing valves are sequentially installed at the gas supply pipes 232a, 232b and 232c, respectively, in this order from upstream sides to downstream sides of the gas supply pipes 232a, 232b and 232c in a gas flow direction. Gas supply pipes 232d, 232e and 232f are connected to the gas supply pipes 232a, 232b and 232c, respectively, at downstream sides of the valve 243a, 243b and 243c of the gas supply pipes 232a, 232b and 232c. MFCs 241d, 241e and 241f and valves 243d, 243e and 243f are sequentially installed at the gas supply pipes 232d, 232e and 232f, respectively, in this order from upstream sides to downstream sides of the gas supply pipes 232d, 232e and 232f in the gas flow direction. For example, each of the gas supply pipes 232a to 232f is made of a metal material such as SUS.

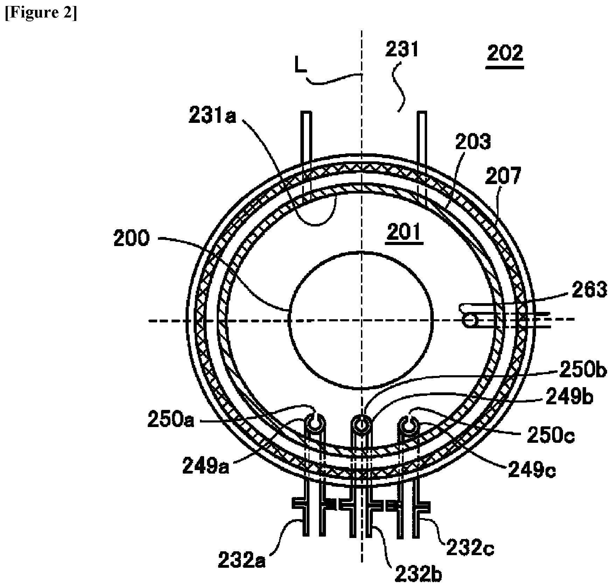

As shown in FIG. 2, each of the nozzles 249a to 249c is installed in an annular space provided between an inner wall of the reaction tube 203 and the wafers 200 when viewed from above, and extends upward from a lower portion toward an upper portion of the reaction tube 203 along the inner wall of the reaction tube 203 (that is, extends upward along an arrangement direction of the wafers 200). That is, each of the nozzles 249a to 249c is installed in a region that is located beside and horizontally surrounds a wafer arrangement region in which the wafers 200 are arranged (stacked) along the wafer arrangement region. When viewed from above, the nozzle 249b is arranged so as to face an exhaust port 231a described later along a straight line (denoted by "L" shown in FIG. 2) with a center of the wafer 200 transferred (loaded) into the process chamber 201 interposed therebetween. The nozzles 249a and 249c are arranged along the inner wall of the reaction tube 203 (that is, along an outer periphery of the wafer 200) such that the straight line L passing through the nozzle 249b and a center of the exhaust port 231a is interposed therebetween. The straight line L may also be referred to as a straight line passing through the nozzle 249b and the center of the wafer 200. That is, it can be said that the nozzle 249c is provided opposite to the nozzle 249a with the straight line L interposed therebetween. The nozzles 249a and 249c are arranged line-symmetrically (that is, in a line symmetry) with respect to the straight line L serving as an axis of symmetry. A plurality of gas supply holes 250a, a plurality of gas supply holes 250b and a plurality of gas supply holes 250c are provided at side surfaces of the nozzles 249a, 249b and 249c, respectively. Gases are supplied via the gas supply holes 250a, the gas supply holes 250b and the gas supply holes 250c, respectively. The gas supply holes 250a, the gas supply holes 250b and the gas supply holes 250c are open toward the exhaust port 231a when viewed from above, and are configured such that the gases are supplied toward the wafers 200 via the gas supply holes 250a, the gas supply holes 250b and the gas supply holes 250c. The gas supply holes 250a, the gas supply holes 250b and the gas supply holes 250c are provided from the lower portion toward the upper portion of the reaction tube 203.

A modifying agent (also referred to as a "modifier" or a "modifying gas") is supplied into the process chamber 201 through the gas supply pipe 232a provided with the MFC 241a and the valve 243a and the nozzle 249a.

A source (also referred to as a "source gas") is supplied into the process chamber 201 through the gas supply pipe 232b provided with the MFC 241b and the valve 243b and the nozzle 249b. For example, the source can be used as one of film-forming agents.

An oxidizing agent (also referred to as an "oxidant" or an "oxidizing gas") is supplied into the process chamber 201 through the gas supply pipe 232c provided with the MFC 241c and the valve 243c and the nozzle 249c. For example, the oxidizing agent can be used as one of the film-forming agents.

An inert gas is supplied into the process chamber 201 via the gas supply pipes 232d to 232f provided with the MFCs 241d to 241f and the valves 243d to 243f, respectively, the gas supply pipes 232a to 232c and the nozzles 249a to 249c. For example, the inert gas may act as a purge gas, a carrier gas, a dilution gas and the like.

A modifying agent supplier (which is a modifying agent supply structure or a modifying agent supply system) is constituted mainly by the gas supply pipe 232a, the MFC 241a and the valve 243a. The modifying agent supplier may also be referred to as a modifying gas supplier (which is a modifying gas supply structure or a modifying gas supply system). A source supplier (which is a source supply structure or a source supply system) is constituted mainly by the gas supply pipe 232b, the MFC 241b and the valve 243b. The source supplier may also be referred to as a source gas supplier (which is a source gas supply structure or a source gas supply system). An oxidizing agent supplier (which is an oxidizing agent supply structure or an oxidizing agent supply system) is constituted mainly by the gas supply pipe 232c, the MFC 241c and the valve 243c. The oxidizing agent supplier may also be referred to as an oxidizing gas supplier (which is an oxidizing gas supply structure or an oxidizing gas supply system). Further, an inert gas supplier (which is an inert gas supply structure or an inert gas supply system) is constituted mainly by the gas supply pipes 232d to 232f, the MFCs 241d to 241f and the valves 243d to 243f.

Any one or an entirety of the gas suppliers described above may be embodied as an integrated gas supply system 248 in which the components such as the valves 243a to 243f and the MFCs 241a to 241f are integrated. The integrated gas supply system 248 is connected to each of the gas supply pipes 232a to 232f. An operation of the integrated gas supply system 248 to supply various gases to the gas supply pipes 232a to 232f, for example, operations such as an operation of opening and closing the valves 243a to 243f and an operation of adjusting flow rates of the gases by the MFCs 241a to 241f may be controlled by a controller 121 which will be described later. The integrated gas supply system 248 may be embodied as an integrated structure (integrated unit) of an all-in-one type or a divided type. The integrated gas supply system 248 may be attached to or detached from the components such as the gas supply pipes 232a to 232f on a basis of the integrated structure. Operations such as maintenance, replacement and addition for the integrated gas supply system 248 may be performed on a basis of the integrated structure.

The exhaust port 231a through which an inner atmosphere of the process chamber 201 is exhausted is provided at a lower side wall of the reaction tube 203. As shown in FIG. 2, the exhaust port 231a is arranged at a location so as to face the nozzles 249a to 249c (the gas supply holes 250a to the gas supply holes 250c) with the wafer 200 interposed therebetween when viewed from above. The exhaust port 231a may be provided so as to extend upward from the lower portion toward the upper portion of the reaction tube 203 along a side wall of the reaction tube 203 (that is, along the wafer arrangement region). An exhaust pipe 231 is connected to the exhaust port 231a. A vacuum pump 246 serving as a vacuum exhaust apparatus is connected to the exhaust pipe 231 through a pressure sensor 245 and an APC (Automatic Pressure Controller) valve 244. The pressure sensor 245 serves as a pressure detector (pressure detection structure) configured to detect an inner pressure of the process chamber 201, and the APC valve 244 serves as a pressure regulator (pressure adjusting structure). With the vacuum pump 246 in operation, the APC valve 244 may be opened or closed to perform a vacuum exhaust operation for the process chamber 201 or stop the vacuum exhaust operation. With the vacuum pump 246 in operation, the inner pressure of the process chamber 201 may be adjusted by adjusting an opening degree of the APC valve 244 based on pressure information detected by the pressure sensor 245. An exhauster (which is an exhaust structure or an exhaust system) is constituted mainly by the exhaust pipe 231, the APC valve 244 and the pressure sensor 245. The exhauster may further include the vacuum pump 246.

A seal cap 219 serving as a furnace opening lid capable of airtightly sealing (or closing) a lower end opening of the manifold 209 is provided under the manifold 209. For example, the seal cap 219 is made of a metal material such as SUS, and is of a disk shape. An O-ring 220b serving as a seal is provided on an upper surface of the seal cap 219 so as to be in contact with the lower end of the manifold 209.

A rotator 267 configured to rotate a boat 217 described later is provided under the seal cap 219. For example, a rotating shaft 255 of the rotator 267 is connected to the boat 217 through the seal cap 219. As the rotator 267 rotates the boat 217, the wafers 200 accommodated in the boat 217 are rotated. The seal cap 219 is elevated or lowered in the vertical direction by a boat elevator 115 serving as an elevating structure provided outside the reaction tube 203. The boat elevator 115 serves as a transfer device (which is a transfer structure or a transfer system) capable of transferring (loading) the boat 217 and the wafers 200 accommodated therein into the process chamber 201 and capable of transferring (unloading) the boat 217 and the wafers 200 accommodated therein out of the process chamber 201 by elevating and lowering the seal cap 219.

A shutter 219s serving as a furnace opening lid capable of airtightly sealing (or closing) the lower end opening of the manifold 209 is provided under the manifold 209. The shutter 219s is configured to close the lower end opening of the manifold 209 when the seal cap 219 is lowered by the boat elevator 115 and the boat 217 is unloaded out of the process chamber 201. For example, the shutter 219s is made of a metal material such as SUS, and is of a disk shape. An O-ring 220c serving as a seal is provided on an upper surface of the shutter 219s so as to be in contact with the lower end of the manifold 209. An opening and closing operation of the shutter 219s such as an elevation operation and a rotation operation is controlled by a shutter opener/closer (which is a shutter opening/closing structure) 115s.

The boat 217 (which is a substrate support or a substrate retainer) is configured such that the wafers 200 (for example, 25 wafers to 200 wafers) are accommodated (or supported) in the vertical direction in the boat 217 while the wafers 200 are horizontally oriented with their centers aligned with one another in a multistage manner. That is, the boat 217 is configured such that the wafers 200 are arranged in the vertical direction in the boat 217 while the wafers 200 are horizontally oriented with a predetermined interval therebetween. For example, the boat 217 is made of a heat resistant material such as quartz and SiC. For example, a plurality of heat insulation plates 218 made of a heat resistant material such as quartz and SiC are supported at a lower portion of the boat 217 in a multistage manner.

A temperature sensor 263 serving as a temperature detector is installed in the reaction tube 203. A state of electric conduction to the heater 207 is adjusted based on temperature information detected by the temperature sensor 263 such that a desired temperature distribution of an inner temperature of the process chamber 201 can be obtained. The temperature sensor 263 is provided along the inner wall of the reaction tube 203.

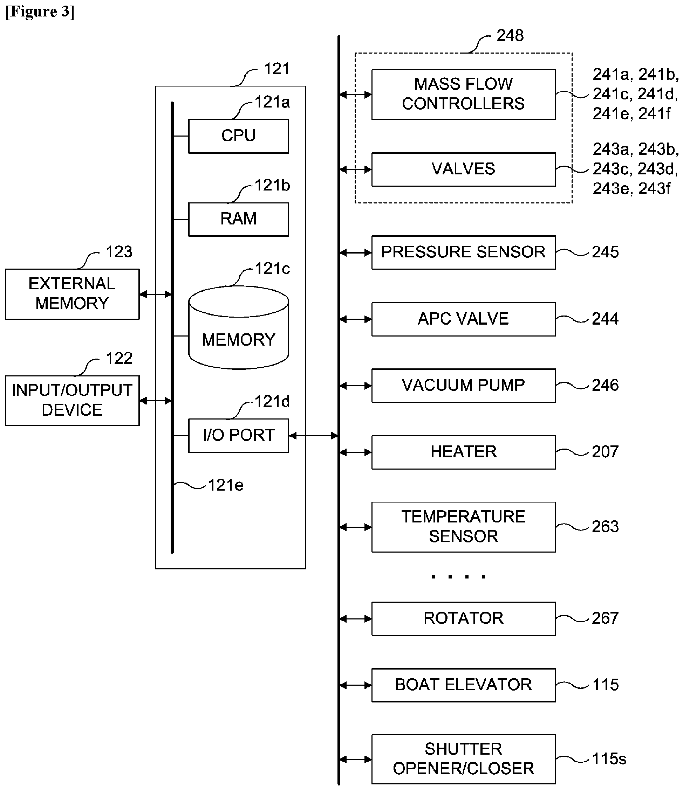

As shown in FIG. 3, the controller 121 serving as a control structure (control apparatus) is constituted by a computer including a CPU (Central Processing Unit) 121a, a RAM (Random Access Memory) 121b, a memory 121c and an I/O port (input/output port) 121d. The RAM 121b, the memory 121c and the I/O port 121d may exchange data with the CPU 121a through an internal bus 121e. For example, an input/output device 122 constituted by a component such as a touch panel is connected to the controller 121. Further, the controller 121 is configured to be capable of being connected to an external memory 123. For example, as the controller 121, the substrate processing apparatus may include a single control structure, or include a plurality of control structures. That is, a control operation of performing a process sequence described later may be performed using the single control structure, or may be performed using the plurality of control structures. Further, the plurality of control structures may be configured as a control system that are connected to one another via a wired or wireless communication network, and an entirety of the control system may perform the control operation of performing the process sequence described below. Thus, in the present specification, the term "controller 121" may refer to the single control structure, may refer to the plurality of control structures, or may refer to the control system configured by the plurality of control structures.

For example, the memory 121c is configured by a component such as a flash memory, a hard disk drive (HDD) and a solid state drive (SSD). For example, a control program configured to control an operation of the substrate processing apparatus and a process recipe containing information on sequences and conditions of a substrate processing described later may be readably stored in the memory 121c. The process recipe is obtained by combining steps (sequences or processes) of the substrate processing described later such that the controller 121 can execute the steps to acquire a predetermined result, and functions as a program. Hereinafter, the process recipe and the control program may be collectively or individually referred to as a "program". In addition, the process recipe may also be simply referred to as a "recipe". Thus, in the present specification, the term "program" may refer to the recipe alone, may refer to the control program alone or may refer to both of the recipe and the control program. The RAM 121b functions as a memory area (work area) where a program or data read by the CPU 121a is temporarily stored.

The I/O port 121d is connected to the components described above such as the MFCs 241a to 241f, the valves 243a to 243f, the pressure sensor 245, the APC valve 244, the vacuum pump 246, the temperature sensor 263, the heater 207, the rotator 267, the boat elevator 115 and the shutter opener/closer 115s.

The CPU 121a is configured to read the control program from the memory 121c and execute the read control program. In addition, the CPU 121a is configured to read the recipe from the memory 121c, for example, in accordance with an operation command inputted from the input/output device 122. In accordance with contents of the read recipe, the CPU 121a may be configured to be capable of controlling various operations such as flow rate adjusting operations for various substances (various gases) by the MFCs 241a to 241f, opening and closing operations of the valves 243a to 243f, an opening and closing operation of the APC valve 244, a pressure regulating operation (pressure adjusting operation) by the APC valve 244 based on the pressure sensor 245, a start and stop operation of the vacuum pump 246, a temperature regulating operation (temperature adjusting operation) by the heater 207 based on the temperature sensor 263, an operation of adjusting a rotation and a rotation speed of the boat 217 by the rotator 267, an elevating and lowering operation of the boat 217 by the boat elevator 115 and an opening and closing operation of the shutter 219s by the shutter opener/closer 115s.

The controller 121 may be embodied by installing the above-described program stored in the external memory 123 into the computer. For example, the external memory 123 may include a magnetic disk such as the HDD, an optical disk such as a CD, a magneto-optical disk such as an MO and a semiconductor memory such as a USB memory and the SSD. The memory 121c or the external memory 123 may be embodied by a non-transitory computer readable recording medium. Hereafter, the memory 121c and the external memory 123 may be collectively or individually referred to as a "recording medium". Thus, in the present specification, the term "recording medium" may refer to the memory 121c alone, may refer to the external memory 123 alone, or may refer to both of the memory 121c and the external memory 123. Instead of the external memory 123, a communication path such as the Internet and a dedicated line may be used for providing the program to the computer.

(2) Substrate Processing

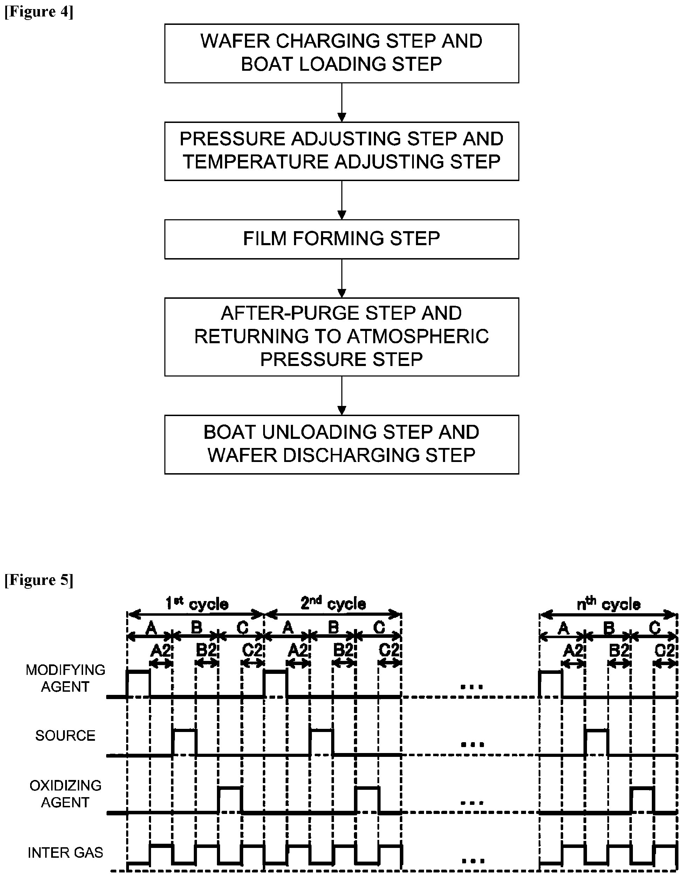

Hereinafter, an example of a process sequence (that is, a film forming sequence) of the substrate processing of forming a film on the wafer 200 serving as the substrate by using the substrate processing apparatus described above, which is a part of a manufacturing process of a semiconductor device, will be described by referring mainly to FIGS. 4 and 5. In the following descriptions, operations of components constituting the substrate processing apparatus are controlled by the controller 121. Referring to FIG. 4, the process sequence (substrate processing flow) may include a wafer charging step, a boat loading step, a pressure adjusting step, a temperature adjusting step, a film forming step, an after-purge step, a returning to an atmospheric pressure step, a boat unloading step and a wafer discharging step.

In the substrate processing (that is, a substrate processing method) according to the present embodiments, the film is formed on the wafer 200 by performing a cycle a predetermined number of times. The cycle according to the present embodiments may include: (a) supplying a first gas containing a NH- group to the wafer 200; (b) supplying the source gas to the wafer 200; and (c) supplying a reactive gas to the wafer 200. In the cycle, (a), (b) and (c) are sequentially performed in this order. By performing the cycle the predetermined number of times, the film containing an element contained in the source gas and an element contained in the reactive gas can be formed on the wafer 200.

More specifically, for example, as shown in the process sequence shown in FIG. 5, the cycle according to the present embodiments may include: a step "A" of supplying the modifying agent serving as the first gas to the wafer 200 to form an adsorption layer on the wafer 200, wherein the adsorption layer contains the modifying agent physically adsorbed on a surface of the wafer 200; a step "B" of supplying the source (source gas) containing a first element to the wafer 200 and reacting the source with the surface of the wafer 200 to form a first layer containing the first element on the wafer 200; and a step "C" of supplying the oxidizing agent serving as the reactive gas to the wafer 200 and reacting the oxidizing agent with the first layer to modify the first layer into a second layer containing the first element and oxygen. The cycle exemplified above is performed a predetermined number of times (n times, where n is an integer of 1 or more). Further, in FIG. 5, "1st cycle" indicates a first execution of the cycle, "2nd cycle" indicates a second execution of the cycle, and "nth cycle" indicates

an $n^{th}$ execution of the cycle.

Further, in the process sequence shown in FIG. 5, the adsorption layer can suppress an adsorption of a by-product (which is generated when the first layer is formed) to at least one of the first layer or the surface of the wafer 200. Further, the first layer may be a film free of elements contained in the modifying agent. That is, the first layer may be free of elements contained in the modifying agent.

In the present specification, such a process sequence of the substrate processing described above may be illustrated as follows. Process sequences of modified examples and other embodiments, which will be described later, will be also represented in the same manner.

(Modifying agent → Source → Oxidizing agent) × n

In the present specification, the term "wafer" may refer to "a wafer itself', or may refer to "a wafer and a stacked structure (aggregated structure) of a predetermined layer (or layers) or a film (or films) formed on a surface of the wafer". In the present specification, the term "a surface of a wafer" may refer to "a surface of a wafer itself', or may refer to "a surface of a predetermined layer (or a predetermined film) formed on a wafer". Thus, in the present specification, "forming a predetermined layer (or a film) on a wafer" may refer to "forming a predetermined layer (or a film) directly on a surface of a wafer itself', or may refer to "forming a predetermined layer (or a film) on a surface of another layer (or another film) formed on a wafer". In the present specification, the terms "substrate" and "wafer" may be used as substantially the same meaning.

In the present specification, the term "agent" may contain at least one selected from the group of a gaseous substance and a liquid substance. The liquid substance may contain a mist substance. That is, each of the modifying agent and the film-forming agents (that is, the source and the oxidizing agent) may contain a gaseous substance, may contain a liquid substance such as a mist substance, or may contain both of the gaseous substance and the liquid substance.

<Wafer Charging Step and Boat Loading Step>

The wafers 200 are charged (transferred) into the boat 217 (wafer charging step). Then, the shutter 219s is moved by the shutter opener/closer 115s to open the lower end opening of the manifold 209 (shutter opening step). Thereafter, as shown in FIG. 1A, the boat 217 supporting the wafers 200 is elevated by the boat elevator 115 and loaded (transferred) into the process chamber 201 (boat loading step). With the boat 217 loaded, the seal cap 219 airtightly seals the lower end of the manifold 209 via the O-ring 220b. In addition, a concave structure such as a trench and a hole may be formed on the surface of the wafer 200. For example, an aspect ratio of the concave structure (that is, a ratio calculated by dividing a depth of an inner space of the concave structure by a width of the inner space of the concave structure) may be 10 or more.

<Pressure Adjusting Step and Temperature Adjusting Step>

After the boat loading step is completed, the vacuum pump 246 vacuum-exhausts (decompresses and exhausts) the inner atmosphere of the process chamber 201 (that is, a space in which the wafers 200 are present (accommodated)) such that the inner pressure of the process chamber 201 reaches and is maintained at a desired pressure (vacuum degree). When the vacuum pump 246 vacuum-exhausts the inner atmosphere of the process chamber 201, the inner pressure of the process chamber 201 is measured by the pressure sensor 245, and the APC valve 244 is feedback-controlled based on the pressure information detected by the pressure sensor 245 (pressure adjusting step). In addition, the heater 207 heats the process chamber 201 such that a temperature of the wafer 200 in the process chamber 201 reaches and is maintained at a desired process temperature. When the heater 207 heats the process chamber 201, the state of the electric conduction to the heater 207 is feedback-controlled based on the temperature information detected by the temperature sensor 263 such that a desired temperature distribution of the inner temperature of the process chamber 201 can be obtained (temperature adjusting step). In addition, a rotation of the wafer 200 is started by the rotator 267. The vacuum pump 246 continuously vacuum-exhausts the inner atmosphere of the process chamber 201, the heater 207 continuously heats the wafer 200 in the process chamber 201 and the rotator 267 continuously rotates the wafer 200 until at least a processing of the wafer 200 is completed.

<Film Forming Step>

Thereafter, the film forming step is performed by sequentially performing a step A, a step B and a step C.

<Step A>

In the step A, the modifying agent is supplied onto the wafer 200 in the process chamber 201.

Specifically, the valve 243a is opened to supply the modifying agent into the gas supply pipe 232a. After a flow rate of the modifying agent is adjusted by the MFC 241a, the modifying agent whose flow rate is adjusted is supplied into the process chamber 201 through the nozzle 249a, and is exhausted through the exhaust port 231a. Thereby, the modifying agent is supplied onto the wafer 200 (modifying agent supply step). In some cases, the modifying agent may be supplied in a diluted state with a dilution gas. In the present step, the valves 243d through 243f may be opened to supply the inert gas into the process chamber 201 through each of the nozzles 249a through 249c.

By supplying the modifying agent to the wafer 200 in accordance with process conditions described below, the modifying agent is physically adsorbed on the surface of the wafer 200. Thereby, it is possible to form, on the wafer 200, the adsorption layer containing the modifying agent physically adsorbed to the surface of the wafer 200. As a result of forming the adsorption layer, some of adsorption sites existing on the surface of the wafer 200 are covered by the adsorption layer, and some other adsorption sites are not covered by the adsorption layer and thereby exposed. In the present specification, for example, the adsorption site existing on the surface of the wafer 200 may contain a hydroxy group (OH group) that terminates the surface of the wafer 200. Further, since the modifying agent contains an organic compound as described below, at least a portion of the surface of the adsorption layer may be terminated with a hydrocarbon group and the like.

It is preferable that a thickness of the adsorption layer is set to be less than one molecular layer. That is, it is preferable that the adsorption layer contains the modifying agent adsorbed so as to cover the surface of the wafer 200 discontinuously. As a result, it is possible to reliably expose some of the adsorption sites (OH groups) existing on the surface of the wafer 200. However, at the present stage, the modifying agent may be physically adsorbed on the surface of the wafer 200 such that the thickness of the adsorption layer is set to be one molecular layer or more (that is, the surface of the wafer 200 is covered with a continuous layer), and the adsorption layer whose thickness is less than one molecular layer may be formed in a step A2 described later by removing a part of the modifying agent contained in the adsorption layer from the surface of the wafer 200.

For example, in the present step, the adsorption layer is formed on at least a surface adjacent to an opening (particularly on a side wall adjacent to the opening) of an inner surface of the concave structure formed on the surface of the wafer 200. Further, as will be described later, in the present step, it is more preferable that the adsorption layer is formed on a bottom surface and side walls of the inner surface of the concave structure. In other words, the adsorption layer is also formed on a part of an exposed surface (also referred to as an "adsorption site" or an "exposed portion") of the surface of the wafer 200. In the present specification, for example, the part of the exposed surface is at least the surface adjacent to the opening (particularly the side wall adjacent to the opening) of the inner surface of the concave structure.

After the adsorption layer is formed on the wafer 200, the valve 243a is closed to stop a supply of the modifying agent into the process chamber 201.

After the supply of the modifying agent to the wafer 200 is completed (stopped), as shown in FIG. 5, with the supply of the modifying agent into the process chamber 201 stopped, it is preferable to perform the step A2 of removing a substance such as a gas remaining in the process chamber 201 from the process chamber 201 by exhausting an inside of the process chamber 201. By continuously performing the step A2, it is possible to remove (or desorb) the part of the modifying agent contained in the adsorption layer from the surface of the wafer 200, and it is also possible to adjust a density (thickness) of the adsorption layer formed on the wafer 200 to a desired density (thickness). That is, in the step A2, it is possible to continuously exhaust the inside of the process chamber 201 until the thickness of the adsorption layer reaches the desired density. As a result, by optimizing the thickness of the first layer formed per each cycle, it is possible to adjust a forming rate of a film formed on the wafer 200 to a desired rate which is relatively large. In the step A2, it is preferable to set exhaust conditions in the process chamber 201 (that is, conditions such as an exhaust time and an exhaust speed) such that the forming rate of the film formed on the wafer 200 is adjusted to a desired level.

Further, as shown in FIG. 5, in the step A2, it is preferable that the valves 243d to 243f are opened to supply the inert gas into the process chamber 201 through the nozzles 249a to 249c. That is, in the step A2, it is preferable to exhaust the inside of the process chamber 201 while supplying the inert gas to the wafer 200. In addition, preferably, a step (inert gas purge step) of exhausting the inside of the process chamber 201 while supplying the inert gas to the wafer 200 and a step (vacuum purge step) of exhausting the inside of the process chamber 201 while a supply of the inert gas is stopped may be performed in the step A2 as shown in FIG. 6(a). In addition, preferably, in the step A2, a purge cycle (which includes the step of exhausting the inside of the process chamber 201 while supplying the inert gas to the wafer 200 and the step of exhausting the inside of the process chamber 201 while the supply of the inert gas is stopped) may be performed a plurality number of times. In the purge cycle, the inert gas purge step and the vacuum purge step are performed non-simultaneously.

By performing the step A2 in accordance with one of the examples described above, it is possible to more efficiently remove a part of the modifying agent physically adsorbed on the surface of the wafer 200 from the surface of the wafer 200, and it is also possible to more reliably adjust the density (thickness) of the adsorption layer formed on the wafer 200 to the desired density (thickness). As a result, for example, it is possible to further optimize the thickness of the first layer formed per each cycle and also possible to adjust the forming rate of the film such that the film is formed at a higher rate.

For example, the process conditions of supplying the modifying agent in the step A are as follows:

A supply flow rate of the modifying agent (excluding the dilution gas): from 0.01 g/min to 10 g/min, more preferably from 0.1 g/min to 5 g/min;

A supply flow rate of the dilution gas: from 100 sccm to 100,000 sccm, more preferably from 1,000 sccm to 50,000 sccm;

A supply time (time duration) of supplying the modifying agent: from 1 second to 600 seconds, more preferably from 10 seconds to 300 seconds;

A supply flow rate of the inert gas (for each gas supply pipe): from 0 sccm to 50,000 sccm, more preferably from 5,000 sccm to 15,000 sccm;

A process temperature: from 200 °C to 500 °C, more preferably from 200 °C to 350 °C; and

A process pressure: from 100 Pa to 10,000 Pa, more preferably from 100 Pa to 1,000 Pa.

Further, in the present specification, a notation of a numerical range such as "from 100 sccm to 100,000 sccm" means that a lower limit and an upper limit are included in the numerical range. Therefore, for example, a numerical range "from 100 sccm to 100,000 sccm" means a range equal to or higher than 100 sccm and equal to or less than 100,000 sccm. The same also applies to other numerical ranges described in the present specification. Further, when a supply flow rate of a substance is zero (0) sccm, it refers to a case where the substance is not supplied. The same also applies to the following descriptions.

For example, the process conditions in the step A2 are as follows:

An exhaust time: from 1 second to 600 seconds, more preferably from 10 seconds to 300 seconds; and

The supply flow rate of the inert gas (for each gas supply pipe): from 0 sccm to 100,000 sccm, more preferably from 0 sccm to 50,000 sccm.

As the modifying agent, a gas containing an inorganic compound, a gas containing an organic compound, or a gas containing both the inorganic compound and the organic compound may be used. As the gas containing the inorganic compound, for example, a gas containing a substance such as ammonia ($NH_3$), hydrazine ($N_2H_4$) and diazene ($N_2H_2$) may be used. Further, the inorganic compound may also be referred to as a material free of an organic ligand. As the gas containing the organic compound, a gas containing at least one selected from the group of an amine compound and an organic hydrazine compound may be used. As a gas containing the amine compound, a gas containing at least one selected from the group of a methylamine compound such as monomethylamine, dimethylamine and trimethylamine, an ethylamine compound such as monoethylamine, diethylamine and triethylamine and a methylethylamine compound such as dimethylethylamine and methyldiethylamine may be used. As a gas containing the organic hydrazine compound, a gas containing at least one of methylhydrazine-based gases such as monomethylhydrazine, dimethylhydrazine and trimethylhydrazine may be used. As the modifying agent, a gas containing the NH- group as shown in the present disclosure may be used. As the modifying agent, one or more of the substances exemplified above may be used. Further, as the modifying agent, it is preferable to use a gas that is difficult to chemically adsorb onto the surface of the wafer 200. In order to form the adsorption layer containing the modifying agent physically adsorbed on the surface of the wafer 200, for example, a gas that does not substantially chemically react with the adsorption sites (OH groups) on the surface of the wafer 200 may be preferably used.

Further, as the modifying agent, the supply period of the gas containing the NH- group and the gas containing the organic ligand may overlap at least partially with the supply period of the NH- group, or the supply period of the gas containing the NH- group may be deviated from the supply period of the gas containing the organic ligand and the NH-group.

As the modifying agent, a hydrazine-based inorganic compound and/or the $NH_3$ may be used. However, from a viewpoint of a decomposition temperature, it is preferable to use the $NH_3$ which is more stable. When an inner temperature of the reaction vessel (that is, the temperature of the wafer 200 serving as the substrate) is a low temperature within a range from 100 °C to 200 °C, the hydrazine-based inorganic compound may be used as the modifying agent. That is, by using the hydrazine-based inorganic compound as the modifying agent, it is possible to form the film under low temperature conditions.

From the viewpoint of throughput of manufacturing the semiconductor device, it is preferable to prevent a large temperature change in a process from the supply of the modifying agent and a supply of the source to a supply of the reactive gas performed thereafter. By using the $NH_3$ as the modifying agent, it is possible to form the film without a large temperature change. However, when ozone ($O_3$) is used as the reactive gas, it may be preferable to change the temperature at which the source gas and the reactive gas are supplied from the temperature at which the modifying gas is supplied. In a case where a time for each temperature adjustment can be secured, it is possible to form the film with a high quality.

As the inert gas, for example, nitrogen ($N_2$) gas or a rare gas such as argon (Ar) gas, helium (He) gas, neon (Ne) gas and xenon (Xe) gas may be used. As the inert gas, one or more of the substances exemplified above may be used. The same also applies to each step described below.

<Step B>

After the step A is completed, the source is supplied onto the wafer 200 in the process chamber 201, that is, onto the wafer 200 where the adsorption layer is formed on the surface thereof.

Specifically, the valve 243b is opened to supply the source into the gas supply pipe 232b. After a flow rate of the source is adjusted by the MFC 241b, the source whose flow rate is adjusted is supplied into the process chamber 201 through the nozzle 249b, and is exhausted through the exhaust port 231a. Thereby, the source is supplied onto the wafer 200 (source supply step). The source may be supplied in a diluted state with the dilution gas such as the inert gas. Further, in the present step, the valves 243d through 243f may be opened to supply the inert gas into the process chamber 201 through each of the nozzles 249a through 249c.

By supplying the source to the wafer 200 in accordance with process conditions described below, it is possible to react the source with the surface of the wafer 200. As described later, the source contains a molecule (hereinafter, also referred to as a "source molecule") containing the first element and a ligand bonded to the first element. When the source reaches the surface of the wafer 200, the source reacts with the exposed surface (which is not covered by a modified layer) of the wafer 200, that is, the adsorption sites (OH groups) exposed on the surface of the wafer 200. In other words, some of molecules of the source gas may be adsorbed to a part (which is not covered by the modified layer) of the exposed portion (adsorption sites) on the surface of the wafer 200. Further, some of the molecules of the source gas may be adsorbed to another part (where no adsorption layer is formed) of the exposed portion. In a process of such a reaction, the ligand is desorbed from the first element contained in the source, and the first element (which contains unbonded species due to a desorption of the ligand) is chemically adsorbed (bonded) to the surface of the wafer 200. As the reaction described above progresses, the first layer containing the first element is formed on the wafer 200, that is, on the exposed surface (exposed portion) of the wafer 200, which is not covered by the adsorption layer.

Further, when forming the first layer, a predetermined by-product may be generated. The by-product may contain the ligand desorbed from the first element due to a reaction between the source and the adsorption site exposed on the surface of the wafer 200. Further, for example, the by-product may contain a molecule in which a part of the ligand is desorbed from the molecule (source molecule) containing the first element and the ligand bonded to the first element. Further, for example, the molecule in which the part of the ligand is desorbed from the molecule (source molecule) containing the first element and the ligand bonded to the first element may be generated by a thermal decomposition of the source supplied into the process chamber 201.

As described later, the by-product may contain an organic ligand (organic substance). Further, it is not preferable for the by-product to be adsorbed (adhered) to a surface of the film formed on the wafer 200 or to remain in the film. When the by-product is adsorbed to the surface of the film or when the by-product remains in the film, the thickness of the film may increase. Therefore, when an amount of the adsorption of the by-product or a residual amount of the by-product is non-uniform within the surface of the wafer 200 or within the inner surface (inner wall) of the concave structure on the wafer 200, a thickness uniformity of the film (which is formed on the wafer 200) within the surface of the wafer 200 and/or a step coverage of the film (which is formed within the inner surface of the concave structure) may deteriorate. Further, when the by-product remains in the film, since impurities derived from the by-product in the film may increase, it may decrease a quality of the film.

In order to solve such problems described above, according to the present embodiments, the adsorption layer formed in advance in the step A can suppress the adsorption (adhesion) of the by-product (which is generated when the first layer is formed) to at least one of the first layer or the surface of the wafer 200. Thereby, it is possible to suppress a non-uniform thickness increase (which is uncontrolled) of the film formed on the wafer 200 due to the adsorption of the by-product, and it is also possible to prevent (or suppress) the by-product from remaining in the film.

As one of the reasons why the adsorption of the by-product to at least one of the first layer or the surface of the wafer 200 can be suppressed, it is considered that the adsorption layer formed in the step A can reduce an amount of the exposed surface of the wafer 200, that is, an amount of the adsorption sites exposed on the surface of the wafer 200 (that is, a density per unit area). Thereby, an amount (degree) of the reaction between the source and the surface of the wafer 200 can be appropriately controlled, and as a result, an amount of the ligand desorbed from the first element (that is, a generation amount of the by-product containing the organic ligand) can be reduced.

Further, as another of the reasons why the adsorption of the by-product to at least one of the first layer or the surface of the wafer 200 can be suppressed, it is considered that, in addition to being capable of reducing an amount of the by-product generated when the first layer is formed as described above, the adsorption layer formed in advance in the step A appropriately covers a part of the surface of the wafer 200 so as to prevent the by-product from being adsorbed (physically adsorbed), or the adsorption layer acts to suppress the adsorption (adhesion) of the by-product generated when the first layer is formed to at least one of the first layer or the surface of the wafer 200. As one of the reasons why the adsorption layer acts to suppress the adsorption of the by-product to at least one of the first layer or the surface of the wafer 200, it is considered that the modifying agent physically adsorbed to the surface of the wafer 200 or a part of the modifying agent desorbed from the surface of the wafer 200 can be preferentially adsorbed to the by-product rather than the first layer or the surface of the wafer 200. As a result, it is possible to suppress the adsorption of the by-product to the first layer. By forming the adsorption layer on the inner surface of the concave structure up to the bottom surface and the side walls in advance in the step A, it is possible to sufficiently suppress the adsorption of the by-product to the surface of the wafer 200 and the first layer even at a portion adjacent to the bottom surface of the concave structure, where it may be difficult for the modifying agent to reach.

The by-product with the adsorption is suppressed can be removed from the process chamber 201 by exhausting the inside of the process chamber 201. Further, the modifying agent adsorbed to the by-product can be removed from the process chamber 201 by exhausting the inside of the process chamber 201 in the present step and/or by exhausting the inside of the process chamber 201 in a subsequent step.

After a process of forming the first layer on the wafer 200 is completed, the valve 243b is closed to stop the supply of the source into the process chamber 201.

After the supply of the source to the wafer 200 is completed (stopped), as shown in FIG. 5, with the supply of the source into the process chamber 201 stopped, it is preferable to perform a step B2 of removing a substance such as a gas remaining in the process chamber 201 from the process chamber 201 by exhausting the inside of the process chamber 201.

By performing the step B2, it is possible to remove an atmosphere containing the substance remaining in the process chamber 201 (such as the source which did not react or which did contribute to a formation of the first layer and the by-product with the adsorption is suppressed by the adsorption layer) from the process chamber 201.

Further, by performing the step B2, it is possible to desorb the modifying agent contained in the adsorption layer (that is, the modifying agent physically adsorbed to the surface of the wafer 200) from the surface of the wafer 200. As a result, it is possible to prevent (suppress) the modifying agent from remaining in the film formed on the wafer 200. Thereby, it is possible to form the film whose concentration of the impurities caused by the modifying agent is low.

Further, by performing the step B2, it is possible to remove the by-product adhered to the adsorption layer from the surface of the wafer 200 together with the modifying agent contained in the adsorption layer (that is, the modifying agent physically adsorbed to the surface of the wafer 200). As a result, it is possible to prevent (suppress) the by-product from remaining in the film formed on the wafer 200. Further, it is also possible to form the film whose step coverage and/or thickness uniformity is excellent within the surface of the wafer 200 and whose concentration of the impurities caused by the by-product is low.

Further, as shown in FIG. 5, in the step B2, it is preferable that the valves 243d to 243f are opened to supply the inert gas into the process chamber 201 through the nozzles 249a to 249c. That is, in the step B2, it is preferable to exhaust the inside of the process chamber 201 while supplying the inert gas to the wafer 200. In addition, preferably, a step (inert gas purge step) of exhausting the inside of the process chamber 201 while supplying the inert gas to the wafer 200 and a step (vacuum purge step) of exhausting the inside of the process chamber 201 while the supply of the inert gas is stopped may be performed in the step B2 as shown in FIG. 6(b). In addition, preferably, a purge cycle (which includes the step of exhausting the inside of the process chamber 201 while supplying the inert gas to the wafer 200 and the step of exhausting the inside of the process chamber 201 while the supply of the inert gas is stopped) may be performed a plurality number of times in the step B2. In the purge cycle of the present step, the inert gas purge step and the vacuum purge step are performed non-simultaneously.

By performing the step B2 in accordance with one of the examples described above, it is possible to more efficiently remove a part of the modifying agent physically adsorbed on the surface of the wafer 200 from the surface of the wafer 200, and it is also possible to more reliably obtain the effects described above.

For example, the process conditions of supplying the source in the step B are as follows:

A supply flow rate of the source (excluding the dilution gas): from 0.1 g/min to 10 g/min, more preferably from 0.5 g/min to 5 g/min;
A supply flow rate of the dilution gas: from 100 sccm to 100,000 sccm, more preferably from 1,000 sccm to 50,000 sccm;
A supply time (time duration) of supplying the source: from 10 seconds to 600 seconds, more preferably from 30 seconds to 300 seconds; and
A supply flow rate of the inert gas (for each gas supply pipe): from 0 sccm to 50,000 sccm, more preferably from 5,000 sccm to 15,000 sccm.

The other process conditions of the present step may be set to be substantially the same as those of the step A of supplying the modifying agent.

The process conditions of the step B2 may be set to be substantially the same as those of the step A2.

As the source, a gas containing the molecule containing the first element and the ligand bonded to the first element may be used. As the first element, for example, a metal element, preferably a transition metal element, and more preferably a Group 4 element such as zirconium (Zr), hafnium (Hf) and titanium (Ti) may be used. Further, as the ligand bonded to the first element, for example, the organic ligand, preferably a hydrocarbon group containing at least one selected from the group of an alkyl group (such as a methyl group, an ethyl group, a propyl group and a butyl group), an amino group (at least the NH- group), an alkylamino group, a cyclopentadienyl group, a cyclohexadienyl group and a cycloheptatrienyl group may be used. Preferably, the source contains the first element and a group different from an amine group.

As the source containing zirconium (Zr) as the first element, for example, a gas containing at least one selected from the group of tetrakis (ethylmethylamino) zirconium ($Zr[N(CH_3)C_2H_5]_4$), tetrakis (diethylamino) zirconium ($Zr[N(C_2H_5)_2]_4$), tetrakis (dimethylamino) zirconium ($Zr[N(CH_3)_2]_4$), $Zr(MMP)_4$, $Zr(O\text{-}tBu)_4$ and tris (dimethylaminocyclopentadienyl) zirconium ($(C_5H_5)Zr[N(CH_3)_2]_3$) may be used. As the source, one or more of the substances exemplified above may be used.

As the source containing hafnium (Hf) as the first element, for example, a gas containing at least one selected from the group of tetrakis (ethylmethylamino) hafnium ($Hf[N(CH_3)C_2H_5]_4$), tetrakis (diethylamino) hafnium ($Hf[N(C_2H_5)_2]_4$), tetrakis (dimethylamino) hafnium ($Hf[N(CH_3)_2]_4$), $Hf(O\text{-}tBu)_4$, $Hf(MMP)_4$ and tris (dimethylaminocyclopentadienyl) hafnium ($(C_5H_5)Hf[N(CH_3)_2]_3$) may be used. As the source, one or more of the substances exemplified above may be used.

As the source containing titanium (Ti) as the first element, for example, a gas containing at least one selected from the group of tetrakis (ethylmethylamino) titanium ($Ti[N(CH_3)C_2H_5]_4$), tetrakis (diethylamino) titanium ($Ti[N(C_2H_5)_2]_4$), tetrakis (dimethylamino) titanium ($Ti[N(CH_3)_2]_4$), $Ti(O\text{-}tBu)_4$, $Ti(MMP)_4$ and tris (dimethylaminocyclopentadienyl) titanium ($(C_5H_5)Ti[N(CH_3)_2]_3$) may be used. As the source, one or more of the substances exemplified above may be used.

<Step C>

After the step B is completed, in the step C, for example, the oxidizing agent serving as the reactive gas is supplied onto the wafer 200 in the process chamber 201, that is, onto the wafer 200 where the first layer containing the first element is formed on the surface thereof.

Specifically, the valve 243c is opened to supply the oxidizing agent into the gas supply pipe 232c. After a flow rate of the oxidizing agent is adjusted by the MFC 241c, the oxidizing agent whose flow rate is adjusted is supplied into the process chamber 201 through the nozzle 249c, and is exhausted through the exhaust port 231a. Thereby, the oxidizing agent is supplied onto the wafer 200 (oxidizing agent supply step). The oxidizing agent may be supplied in a diluted state with the dilution gas such as the inert gas and another oxygen-containing gas. Further, in the present step, the valves 243d through 243f may be opened to supply the inert gas into the process chamber 201 through each of the nozzles 249a through 249c.

By supplying the oxidizing agent to the wafer 200 in accordance with process conditions described below, by reacting the oxidizing agent with the first layer, it is possible to modify (oxidize) the first layer into a second layer containing the first element and oxygen (O).

Further, even when forming the second layer, a by-product may be generated. The by-product generated when the second layer is formed (also referred to as a "by-product in the present step") may contain a ligand desorbed from the first layer due to a reaction between the oxidizing agent and the first layer. Similar to the by-product generated when the first layer is formed, the by-product in the present step may contain an organic ligand (organic substance). Further, it is not preferable for the by-product in the present step to be adsorbed (adhered) to the second layer or to remain in the film formed on the wafer 200.

In order to solve such problems described above, according to the present embodiments, the adsorption layer formed in advance in the step A can suppress the adsorption (adhesion) of the by-product (which is generated when the second layer is formed) to at least one of the second layer or the surface of the wafer 200. Similar to the step B, it is considered that the adsorption layer formed in advance in the step A appropriately covers a part of the surface of the wafer 200, or the adsorption layer acts to suppress (or inhibit) the adsorption (adhesion) of the by-product (which is generated when the second layer is formed) to the second layer.

The by-product in the present step whose adsorption is suppressed can be removed from the process chamber 201 by exhausting the inside of the process chamber 201. Further, a part of the by-product in the present step whose adsorption to at least one of the second layer or the surface of the wafer 200 is suppressed may be adsorbed (adhered) to the adsorption layer.

After a process of forming the second layer on the wafer 200 is completed, the valve 243c is closed to stop a supply of the oxidizing agent into the process chamber 201.

After the supply of the oxidizing agent to the wafer 200 is completed (stopped), as shown in FIG. 5, with the supply of the oxidizing agent into the process chamber 201 stopped, it is preferable to perform a step C2 of removing a substance such as a gas remaining in the process chamber 201 from the process chamber 201 by exhausting the inside of the process chamber 201.

By performing the step C2, it is possible to remove an atmosphere containing the substance remaining in the process chamber 201 (such as the oxidizing agent which did not react or which did contribute to a formation of the second layer and the by-product whose adsorption is suppressed by the adsorption layer) from the process chamber 201.

Further, by performing the step C2, it is possible to desorb the modifying agent contained in the adsorption layer (that is, the modifying agent physically adsorbed to the surface of the wafer 200) from the surface of the wafer 200. As a result, it is possible to prevent (suppress) the modifying agent from remaining in the film formed on the wafer 200. Thereby, it is possible to form the film whose concentration of the impurities caused by the modifying agent is low.

Further, by performing the step C2, it is possible to remove the by-product adhered to the adsorption layer from the surface of the wafer 200 together with the modifying agent contained in the adsorption layer (that is, the modifying agent physically adsorbed to the surface of the wafer 200). As a result, it is possible to prevent (suppress) the by-product from remaining in the film formed on the wafer 200. Further, it is also possible to form the film whose step coverage and/or thickness uniformity is excellent within the surface of the wafer 200 and whose concentration of the impurities caused by the by-product is low.

Further, as shown in FIG. 5, in the step C2, it is preferable that the valves 243d to 243f are opened to supply the inert gas into the process chamber 201 through the nozzles 249a to 249c. That is, in the step C2, it is preferable to exhaust the inside of the process chamber 201 while supplying the inert gas to the wafer 200. In addition, preferably, a step (inert gas purge step) of exhausting the inside of the process chamber 201 while supplying the inert gas to the wafer 200 and a step (vacuum purge step) of exhausting the inside of the process chamber 201 while the supply of the inert gas is stopped may be performed in the step C2 as shown in FIG. 6(c). In addition, preferably, a purge cycle (which includes the step of exhausting the inside of the process chamber 201 while supplying the inert gas to the wafer 200 and the step of exhausting the inside of the process chamber 201 while the supply of the inert gas is stopped) may be performed a plurality number of times in the step C2. In the purge cycle of the present step, the inert gas purge step and the vacuum purge step are performed non-simultaneously.

By performing the step C2 in accordance with one of the examples described above, it is possible to more efficiently remove a part of the modifying agent physically adsorbed on the surface of the wafer 200 from the surface of the wafer 200, and it is also possible to more reliably obtain the effects described above.

For example, the process conditions of supplying the oxidizing agent in the step C are as follows:

A supply flow rate of the oxidizing agent: from 100 sccm to 100,000 sccm, more preferably from 1,000 sccm to 10,000 sccm;

A supply time (time duration) of supplying the oxidizing agent: from 10 seconds to 600 seconds, more preferably from 30 seconds to 300 seconds; and

A supply flow rate of the inert gas (for each gas supply pipe): from 0 sccm to 50,000 sccm, more preferably from 5,000 sccm to 15,000 sccm.

The other process conditions of the present step may be set to be substantially the same as those of the step A of supplying the modifying agent.

The process conditions of the step C2 may be set to be substantially the same as those of the step A2.

As the oxidizing agent, for example, a gas containing oxygen (O) and/or a gas containing oxygen (O) and hydrogen (H) may be used. As the gas containing oxygen and hydrogen, for example, a substance such as water vapor ($H_2O$ gas), hydrogen peroxide ($H_2O_2$) gas, a gaseous mixture of hydrogen ($H_2$) gas and oxygen ($O_2$) gas and a gaseous mixture of the $H_2$ gas and ozone ($O_3$) gas may be used. As the gas containing oxygen, for example, a substance such as the $O_2$ gas and the $O_3$ gas may be used. For example, the $O_3$ gas may be generated from the $O_2$ gas by an ozonizer. Therefore, a nozzle from the ozonizer ejects a gas containing the $O_2$ and the $O_3$. The $O_3$ generated in a manner described above is supplied to the process vessel and the wafer 200 serving as the substrate. Specifically, a gaseous mixture of the $O_2$ gas and the $O_3$ gas is supplied through the nozzle (that is, an oxidizing agent supply nozzle). In addition, the inert gas may be supplied through nozzles other than the oxidizing agent supply nozzle. By supplying the inert gas, it is possible to prevent the $O_3$ gas from entering the nozzles other than the oxidizing agent supply nozzle. When both of the oxidizing agent and the inert gas are not supplied through the oxidizing agent supply nozzle, the $O_3$ gas, the $O_2$ gas and the inert gas may be supplied to the process vessel and the wafer 200 serving as the substrate through the oxidizing agent supply nozzle and the nozzles other than the oxidizing agent supply nozzle.

Further, in the present specification, the description of two gases such as "a gaseous mixture of hydrogen ($H_2$) gas and oxygen ($O_2$) gas" refers to a mixed gas of the two gases such as the $H_2$ gas and the $O_2$ gas. When the mixed gas of the two gases is supplied, the two gases may be mixed (pre-mixed) in a supply pipe and then supplied into the process chamber 201. Alternatively, the two gases may be separately supplied into the process chamber 201 through different supply pipes, and the two gases separately supplied into the process chamber 201 may be mixed (post-mixed) in the process chamber 201.

<Performing Cycle Predetermined Number of Times>

By performing the cycle wherein the step A to the step C described above are performed non-simultaneously (that is, in a non-synchronized manner) in this order a predetermined number of times (n times, wherein n is an integer equal to or greater than 1), it is possible to form a film containing the first element and oxygen (O) (that is, an oxide film containing the first element) on the wafer 200, that is, on the surface of the wafer 200 including the inner surface of the concave structure formed on the surface of the wafer 200. It is preferable that the cycle described above is repeatedly performed a plurality number of times. That is, it is preferable that the cycle is repeatedly performed the plurality number of times until a thickness of a stacked film (that is, the oxide film containing the first element) reaches a desired thickness while a thickness of the second layer formed per each cycle is smaller than the desired thickness.

<After-purge Step and Returning to Atmospheric Pressure Step>

After a process of forming the film on the wafer 200 is completed, the inert gas serving as the purge gas is supplied into the process chamber 201 through each of the nozzles 249a, 249b and 249c, and then is exhausted through the exhaust port 231a. Thereby, the inside of the process chamber 201 is purged with the purge gas. As a result, a substance such as a gas remaining in the process chamber 201 and reaction by-product remaining in the process chamber 201 are removed from the process chamber 201 (after-purge step). Thereafter, the inner atmosphere of the process chamber 201 is replaced with the inert gas (substitution by inert gas), and the inner pressure of the process chamber 201 is returned to the normal pressure (atmospheric pressure) (returning to atmospheric pressure step).

<Boat Unloading Step and Wafer Discharging Step>

Thereafter, the seal cap 219 is lowered by the boat elevator 115 and the lower end of the manifold 209 is opened. Then, the boat 217 with the wafers 200 (which are processed and supported in the boat 217) is unloaded (transferred) out of the reaction tube 203 through the lower end of the manifold 209 (boat unloading step). After the boat 217 is unloaded, the shutter 219s is moved such that the lower end opening of the manifold 209 is sealed by the shutter 219s through the O-ring 220c (shutter closing step). Then, the wafers 200 (which are processed) are discharged (transferred) from the boat 217 unloaded out of the reaction tube 203 (wafer discharging step).

(3) Effects According to Present Embodiments

According to the present embodiments, it is possible to obtain one or more of the following effects.

(a) When performing the cycle including the step A to the step C the predetermined number of times, by suppressing the adsorption of the by-product (which is generated when the first layer is formed) to at least one of the first layer or the surface of the wafer 200 by the adsorption layer, it is possible to improve the quality of the film formed on the wafer 200. For example, it is possible to improve the step coverage and/or the thickness uniformity of the film (which is formed on the wafer 200) within the surface of the wafer 200. Further, for example, it is possible to form, on the wafer 200, the film whose concentration of the impurities caused by the by-product (which is generated when the first layer is formed) is low. For example, the concentration of the impurities contained in the film formed on the wafer 200 by performing the cycle including the step A to the step C the predetermined number of times can be reduced as compared with that of impurities contained in a film formed on the wafer 200 by performing a cycle including the step B and the step C and without including the step A the same predetermined number of times.

(b) When performing the cycle including the step A to the step C the predetermined number of times, by suppressing the adsorption of the by-product (which is generated when the second layer is formed) to at least one of the second layer or the surface of the wafer 200 by the adsorption layer, it is possible to further improve the quality of the film formed on the wafer 200. For example, it is possible to further improve the step coverage and/or the thickness uniformity of the film (which is formed on the wafer 200) within the surface of the wafer 200. Further, for example, it is possible to form, on the wafer 200, the film whose concentration of the impurities caused by the by-product (which is generated when the second layer is formed) is low.

(c) Since the modifying agent contained in the adsorption layer is physically adsorbed to the surface of the wafer 200, it can be easily desorbed from the surface of the wafer 200 when the cycle including step A to the step C is performed. As a result, it is possible to adjust the forming rate of the film formed on the wafer 200 to a desired rate. Thereby, it is possible to improve a productivity of the film forming step (film forming process). Further, by preventing (suppressing) the modifying agent from remaining in the film formed on the wafer 200, it is possible to improve the quality of the film.

For example, in the step A, after supplying the modifying agent to the wafer 200, by performing the step A2 of exhausting the inside of the process chamber 201, it is possible to remove a part of the modifying agent contained in the adsorption layer from the surface of the wafer 200. Thereby, it is also possible to adjust the density (thickness) of the adsorption layer formed on the wafer 200 to a desired density (thickness). As a result, when forming the film on the wafer 200, it is possible to adjust the forming rate of the film to a desired rate. Further, by preventing (suppressing) the modifying agent from remaining in the film formed on the wafer 200, it is possible to form the film whose concentration of the impurities caused by the modifying agent is low.

Further, for example, in the step B, after supplying the source to the wafer 200, by performing the step B2 of exhausting the inside of the process chamber 201, it is possible to desorb the modifying agent contained in the adsorption layer from the surface of the wafer 200. Thereby, by preventing (suppressing) the modifying agent from remaining in the film formed on the wafer 200, it is possible to form the film whose concentration of the impurities caused by the modifying agent is low. Further, by removing the by-product adhered to the adsorption layer from the surface of the wafer 200 together with the modifying agent contained in the adsorption layer, it is possible to prevent (suppress) the by-product from remaining in the film formed on the wafer 200. As a result, it is also possible to form the film whose step coverage and/or thickness uniformity is excellent within the surface of the wafer 200 and whose concentration of the impurities caused by the by-product (which is generated when the first layer is formed) is low.

Further, for example, in the step C, after supplying the oxidizing agent to the wafer 200, by performing the step C2 of exhausting the inside of the process chamber 201, it is possible to desorb the modifying agent contained in the adsorption layer from the surface of the wafer 200. Thereby, by preventing (suppressing) the modifying agent from remaining in the film formed on the wafer 200, it is possible to form the film whose concentration of the impurities caused by the modifying agent is low. Further, by removing the by-product adhered to the adsorption layer from the surface of the wafer 200 together with the modifying agent contained in the adsorption layer, it is possible to prevent (suppress) the by-product from remaining in the film formed on the wafer 200. As a result, it is also possible to form the film whose step coverage and/or thickness uniformity is excellent within the surface of the wafer 200 and whose concentration of the impurities caused by the by-product (which is generated when the second layer is formed) is low.

(d) In the step A, by forming a discontinuous adsorption layer (that is, the adsorption layer whose thickness is set to be less than one molecular layer) on the wafer 200, in other words, by exposing some of the adsorption sites (OH groups) existing on the surface of the wafer 200, it is possible to bond the first element contained in the source to the adsorption site existing on the surface of the wafer 200 in the step B. As a result, when forming the film on the wafer 200, it is possible to adjust the forming rate of the film to a desired rate.

(e) The effects described above are particularly preferable when the concave structure is formed on the surface of the wafer 200 and the film is to be formed on the inner surface of the concave structure.

For example, in a case where the film is to be formed on the inner surface of the concave structure formed on the surface of the wafer 200, the by-product generated within the concave structure pass through the opening of the concave structure when being discharged from the concave structure. Therefore, an exposure amount of the by-product near the opening of the concave structure tends to be larger than that of the by-product near a bottom portion of the concave structure. Thereby, the by-product can be easily adsorbed near the opening of the concave structure. As a result, the film formed near the opening of the concave structure tends to be thicker than the film formed near the bottom portion of the concave structure, and the concentration of the impurities caused by the by-product in the film formed near the opening of the concave structure tends to be higher. In particular, when an aspect ratio of the concave structure is 10 or more, the problems described above may occur significantly.

According to the present embodiments, as described above, it is possible to suppress the adsorption of the by-product (which is generated when the first layer is formed and/or when the second layer is formed) to at least one of the first layer (or the second layer) or the surface of the wafer 200 by the adsorption layer. Thereby, it is possible to solve the problems described above, and it is also possible to improve the step coverage of the film formed on the inner surface of the concave structure formed on the wafer 200. Further, in a case where the adsorption layer is formed on at least the bottom surface or the side walls of the inner surface of the concave structure in the step A, that is, in a case where the adsorption layer is formed not only on the opening but also on an entirety of the inner surface of the concave structure, it is also possible to suppress the adsorption of the by-product at the bottom surface and the side walls. As a result, it is possible to further improve the step coverage of the film formed on the wafer 200, and it is also possible to form the film whose concentration of the impurities caused by the by-product is low over the entirety of the inner surface of the concave structure.

(f) It is also possible to obtain substantially the same effects described above even when a predetermined substance (which is a gaseous substance or a liquid substance) is appropriately selected from the group of the substances exemplified as the modifying agent, the substances exemplified as the source, the substances exemplified as the oxidizing agent and the substances exemplified as the inert gas, and is used to form the film.

<Other Embodiments of Present Disclosure>

While the technique of the present disclosure is described in detail by way of the embodiments described above, the technique of the present disclosure is not limited thereto. The technique of the present disclosure may be modified in various ways without departing from the scope thereof.

For example, the source gas may be a gas containing at least one selected from the group of the amino group and the organic ligand. The NH- group in the source gas containing the amino group is difficult to adsorb to a NH- termination on the wafer 200, and the NH- termination on the wafer 200 acts like an inhibitor.

Further, a constituent element of the first layer does not include a constituent element of the modifying gas. That is, the first layer is free of the constituent element of the modifying gas. For example, the second layer may be a film containing the first element of the source and oxygen (O) from the oxidizing agent.

For example, as in a process sequence shown in FIG. 7(a) and described below, in the step A, a first modifying gas containing the NH- group is supplied to the wafer 200. The first modifying gas may be supplied without supplying a second modifying gas, and the first modifying gas may not contain the organic ligand. For example, the first modifying gas may contain the $NH_3$. In a case where the $NH_3$ is supplied, since a molecule of the $NH_3$ does not contain a substance such as carbon (C) and carbon hydride (CH), it is possible to reduce a possibility that the substance such as carbon (C) and carbon hydride (CH) from the first modifying gas remains in the first layer deposited in a later step.

Further, in the step A, the second modifying gas containing the organic ligand may be supplied in addition to the first modifying gas, as in process sequences described below. Further, the second modifying gas may contain the NH- group in addition to the organic ligand. When the second modifying gas is further supplied in addition to the first modifying gas, for example, as in the process sequence shown in FIG. 7(b) and described below, in the step A, the first modifying gas may be supplied after the second modifying gas is supplied. Alternatively, for example, as in the process sequence shown in FIG. 7(c) and described below, the second modifying gas may be supplied after the first modifying gas is supplied in the step A. Alternatively, for example, as in the process sequence shown in FIG. 7(d) and described below, a period during which the first modifying gas is supplied and a period during which the second modifying gas is supplied may partially overlap with each other in the step A. Alternatively, for example, the first modifying gas and the second modifying gas may be supplied during the same period as in the process sequence shown in FIG. 7(e) and described below.

For example, at least one of the first modifying gas or the second modifying gas may be supplied for a plurality of periods. Such a condition can be satisfied in any case of FIGS. 7(a) to 7(e). A supply method described above may also be referred to as a "time division flow". When the time division flow is used, the NH- termination tends to be formed mainly on an upper portion of the concave structure. By using the time division flow described above, it is possible to reduce a supply amount in one pulse supply. In addition, in a subsequent pulse supply, it is possible to supply the $NH_3$ to a location where the NH- group has not yet been adsorbed (for example, the wafer 200 and the first layer being formed), and it is also possible to uniformly form the NH- termination near the opening of the concave structure of the wafer 200.

In the step A, the first modifying gas is supplied to the process chamber 201 and to the wafer 200 in the process chamber 201 in a state where a decomposition of the first modifying gas is suppressed, preferably in an undecomposed state (hereinafter, such states may also be collectively referred to as a "decomposition-suppressed state"). For example, the decomposition-suppressed state is satisfied when a temperature of the reaction vessel is less than a decomposition temperature of the modifying gas. Such a condition may also be satisfied both in the cases of FIGS. 7(a) to 7(e) and in the case of the time division flow.

The gas containing the NH- group (for example, the $NH_3$ gas) begins to decompose at a low temperature of 100 °C, and most of the $NH_3$ decomposes at around 400 °C. When the modifying gas is supplied at its decomposition temperature, for example, less than 400 °C or at a temperature slightly lower than 400 °C (for example, 350 °C), the decomposition-suppressed state can be satisfied. In addition to the temperature, the decomposition-suppressed state is also related to parameters such as a flow velocity of the gas supplied as described above, a flow rate of the gas and an inner pressure of the process vessel. For example, when the gas is supplied at a high flow velocity, it is possible to reduce a time during which molecules of the gas supplied at the high flow velocity are exposed to the temperatures described above. As a result, the thermal energy imparted to the molecules of the gas is reduced. Thereby, it is possible to increase an amount of the gas that reaches the surface of the wafer 200 serving as the substrate before the molecules of the gas decompose.

For example, a pressure condition in the process chamber 201 may be set such that a pressure in the step A is set to be higher than a pressure in the step B, as in a process sequence shown below. The pressure condition described above may be satisfied in the cases of FIGS. 7(a) to 7(e), in the case of the time division flow and in the case of the decomposition-suppressed state.

For example, a first supply condition of the first modifying gas and the source gas may be set such that a supply amount (for example, the flow rate) of the first modifying gas is set to be less than a supply amount (for example, the flow rate) of the source gas, as in a process sequence shown below. The first supply condition described above may be satisfied in the cases of FIGS. 7(a) to 7(e), in the case of the time division flow, in the case of the decomposition-suppressed state and in the case of the pressure condition described above.

For example, a second supply condition of the first modifying gas and the reactive gas may be set such that the supply amount (for example, the flow rate) of the first modifying gas is set to be less than a supply amount (for example, the flow rate) of the reactive gas, as in a process sequence shown below. The second supply condition described above may be satisfied in the cases of FIGS. 7(a) to 7(e), in the case of the time division flow, in the case of the decomposition-suppressed state, in the case of the pressure condition described above and in the case of the first supply condition described above.

For example, as in a process sequence shown in FIG. 6(d) and described below, in the step B, a source supply cycle may be performed a plurality number of times (m times, where m is an integer of 2 or more). The source supply cycle includes a step of supplying the source to the wafer 200 and a step (exhaust step) of exhausting the inside of the process chamber 201 while the supply of the source is stopped. The process conditions in each step described above may be substantially the same as the process conditions in the source supply step or the step B2 described above.

$$(\text{Modifying agent} \to (\text{Source} \to \text{Exhaust}) \times m \to \text{Oxidizing agent}) \times n$$

When a continuous supply time of the source becomes longer, the thermal decomposition of the source may progress, and the amount of the by-product generated by the thermal decomposition may increase. In order to suppress such an increase in the amount of the by-product caused by the thermal decomposition, it is preferable to shorten the continuous supply time of the source. According to the present embodiments, by supplying the source in a time-divided manner, it is possible to shorten the continuous supply time, and it is also possible to form the first layer while suppressing the increase (generation) of the by-product.

In addition, in such a case described above, each time the source supply cycle is performed, it is possible to desorb the modifying agent contained in the adsorption layer from the surface of the wafer 200, and it is also possible to further prevent (suppress) the modifying agent from remaining in the film formed on the wafer 200. Further, each time the source supply cycle is performed, it is possible to remove the by-product adhered to the adsorption layer from the surface of the wafer 200 together with the modifying agent contained in the adsorption layer, and it is also possible to further prevent (suppress) the by-product from remaining in the film formed on the wafer 200. As a result, it is possible to form, on the wafer 200, the film whose step coverage and/or thickness uniformity is more excellent within the surface of the wafer 200 and whose concentration of the impurities caused by the modifying agent and/or the by-product is low.

For example, according to the present embodiments, in the exhaust step of the source supply cycle shown in the process sequence shown in FIG. 6(d), it is preferable that the valves 243d to 243f are opened to supply the inert gas serving as the purge gas into the process chamber 201 through the nozzles 249a to 249c.

For example, as in a process sequence shown in FIG. 6(e) and described below, in the source supply cycle described above, a step of supplying the modifying agent to the wafer 200 may be further performed.

$$(\text{Modifying agent} \to (\text{Source} \to \text{Exhaust} \to \text{Modifying agent} \to \text{Exhaust}) \times m \to \text{Oxidizing agent}) \times n$$

or

$$(\text{Modifying agent} \to (\text{Source} \to \text{Exhaust} \to \text{Modifying agent}) \times m \to \text{Oxidizing agent}) \times n$$

When the source supply cycle is repeatedly performed as described above, the modifying agent contained in the adsorption layer is desorbed from the surface of the wafer 200 each time the source supply cycle is performed. As a result, the modifying agent constituting the adsorption layer may become insufficient. In such a case, by supplying the modifying agent during the source supply cycle as described above, it is possible to supplement the modifying agent which is insufficient. As a result, it is possible to more reliably suppress the adsorption of the by-product (which is generated each time the source supply cycle is performed) to at least one of the first layer or the surface of the wafer 200 by the adsorption layer, and it is also possible to further improve the quality of the film formed on the wafer 200.

For example, according to the present embodiments, in the exhaust step of the source supply cycle shown in the process sequence shown in FIG. 6E, it is preferable that the valves 243d to 243f are opened to supply the inert gas serving as the purge gas into the process chamber 201 through the nozzles 249a to 249c. Further, in the source supply cycle of this embodiment, after the step of supplying the modifying agent, the step of exhausting the inside of the process chamber 201 may not be performed.

For example, as in a process sequence shown in FIG. 6(f) and described below, in the step C, an oxidizing agent supply cycle may be performed a plurality number of times (m times, where m is an integer of 2 or more). The oxidizing agent supply cycle includes a step of supplying the oxidizing agent to the wafer 200 and a step (exhaust step) of exhausting the inside of the process chamber 201 while the supply of the oxidizing agent is stopped. The process conditions in each step described above may be substantially the same as the process conditions in the oxidizing agent supply step or the step C2 described above.

$$(\text{Modifying agent} \rightarrow \text{Source} \rightarrow (\text{Oxidizing agent} \rightarrow \text{Exhaust}) \times m) \times n$$

In addition, in such a case described above, each time the oxidizing agent supply cycle is performed, it is possible to desorb the modifying agent contained in the adsorption layer from the surface of the wafer 200, and it is also possible to further prevent (suppress) the modifying agent from remaining in the film formed on the wafer 200. Further, each time the oxidizing agent supply cycle is performed, it is possible to remove the by-product adhered to the adsorption layer from the surface of the wafer 200 together with the modifying agent contained in the adsorption layer, and it is also possible to further prevent (suppress) the by-product from remaining in the film formed on the wafer 200. As a result, it is possible to form, on the wafer 200, the film whose step coverage and/or thickness uniformity is more excellent within the surface of the wafer 200 and whose concentration of the impurities caused by the modifying agent and/or the by-product is low.

For example, according to the present embodiments, in the exhaust step of the oxidizing agent supply cycle shown in the process sequence shown in FIG. 6(f), it is preferable that the valves 243d to 243f are opened to supply the inert gas serving as the purge gas into the process chamber 201 through the nozzles 249a to 249c.

It is preferable that recipes used in processes are prepared individually in accordance with contents of the processes and stored in the memory 121c via an electric communication line or the external memory 123. When starting each process, it is preferable that the CPU 121a selects an appropriate recipe among the recipes stored in the memory 121c in accordance with the contents of each process. Thus, various films of different composition ratios, qualities and thicknesses can be formed in a reliably reproducible manner by using a single substrate processing apparatus (that is, the substrate processing apparatus described above). In addition, since a burden on an operating personnel in charge of the substrate processing apparatus can be reduced, various processes can be performed quickly while avoiding an error in operating the substrate processing apparatus.

The recipe described above is not limited to creating a new recipe. For example, the recipe may be prepared by changing an existing recipe stored (or installed) in the substrate processing apparatus in advance. When changing the existing recipe to a new recipe, the new recipe may be installed in the substrate processing apparatus via the electric communication line or a recording medium in which the new recipe is stored. Further, the existing recipe already stored in the substrate processing apparatus may be directly changed to the new recipe by operating the input/output device 122 of the substrate processing apparatus.

For example, the embodiments described above are described by way of an example in which a batch type substrate processing apparatus capable of simultaneously processing a plurality of substrates is used to form the film. However, the technique of the present disclosure is not limited thereto. For example, the technique of the present disclosure may also be preferably applied when a single wafer type substrate processing apparatus capable of simultaneously processing one or several substrates at a time is used to form the film. For example, the embodiments described above are described by way of an example in which a substrate processing apparatus including a hot wall type process furnace is used to form the film. However, the technique of the present disclosure is not limited thereto. For example, the technique of the present disclosure may also be preferably applied when a substrate processing apparatus including a cold wall type process furnace is used to form the film.

For example, the embodiments described above are described by way of an example in which the adsorption layer is formed on a part of the exposed portion of the concave structure formed on the wafer 200 and the molecule of the source gas is adsorbed on the other part of the exposed portion. However, the technique of the present disclosure is not limited thereto. For example, the wafer 200 may be processed by supplying the modifying agent to the entirety of the surface of the wafer 200 and then supplying the source gas. As a result, it is possible to reduce a speed (rate) at which the film is formed over the entirety of the surface of the wafer 200, that is, it is possible to reduce the forming rate of the film. Thereby, it is possible to form a dense film as the film formed on the wafer 200. Further, it is possible to improve characteristics of the film formed on the wafer 200. In the present specification, the characteristics of the film may refer to the thickness uniformity of the film (which is formed on the wafer 200) within the surface of the wafer 200, may refer to a thickness uniformity of the film between the wafers 200, or may refer to both of them. In the present specification, the term "thickness uniformity of the film between the wafers 200" may refer to the thickness uniformity of the film between the wafers 200 processed by the single wafer type substrate processing apparatus, or may refer to the thickness uniformity of the film between the wafers 200 simultaneously processed by the batch type substrate processing apparatus. In particular, when the gas is supplied through edges (sides) of the wafers 200 (or an edge of the wafer 200), the characteristics of the film between the wafers 200 may become non-uniform. In such a case, the process of the present disclosure is preferable.

For example, the embodiments described above are described by way of an example in which the process sequence described above is performed in the same process vessel of the same processing apparatus (that is, in-situ). However, the technique of the present disclosure is not limited thereto. For example, a step in the process sequence described above and another step in the process sequence described above may be performed in different process vessels of different processing apparatuses (that is, ex-situ), or may be performed in different process vessels of the same processing apparatus.

For example, the embodiments described above are described by way of an example in which the oxidizing agent is supplied to the wafer 200 to form the oxide film. However, the technique of the present disclosure is not limited thereto. For example, the technique of the present disclosure may also be applied to a case of forming , for example, a film of a single element, a nitride film, an oxynitride film and a carbide film on the wafer 200 (that is, on the concave structure). In such a case, as the reactive gas, at least one selected from the group of the oxidizing agent, a nitriding agent, a carbonizing agent and a reducing agent may be used. Further, as the oxidizing agent, for example, the substance (gas) exemplified above as the oxidizing agent in the embodiments described above may be used. As the nitriding agent, for example, a substance containing at least one selected from the group of the $NH_3$ gas, $N_2H_4$ gas and $N_2H_2$ gas may be used. As the carbonizing agent, for example, a substance containing at least one selected from the group of a gas containing an alkane and a gas containing an alcohol such as methanol, ethanol and propanol may be used. Further, as the reducing agent, for example, a substance containing at least one selected from the group of the $H_2$ gas, the $NH_3$ gas, monosilane ($SiH_4$) gas, disilane ($Si_2H_6$) gas, trisilane ($Si_3H_8$) gas, monoborane ($BH_4$) gas, diborane ($B_2H_6$) gas and triborane ($B_3H_8$) gas may be used.

The process sequences and the process conditions of each process using the substrate processing apparatuses described above may be substantially the same as those of the embodiments described above. Even in such a case, it is possible to obtain substantially the same effects as in the embodiments described above.

Further, the embodiments described above may be appropriately combined. The process sequences and the process conditions of each combination thereof may be substantially the same as those of the embodiments described above.

<Example of Embodiments>

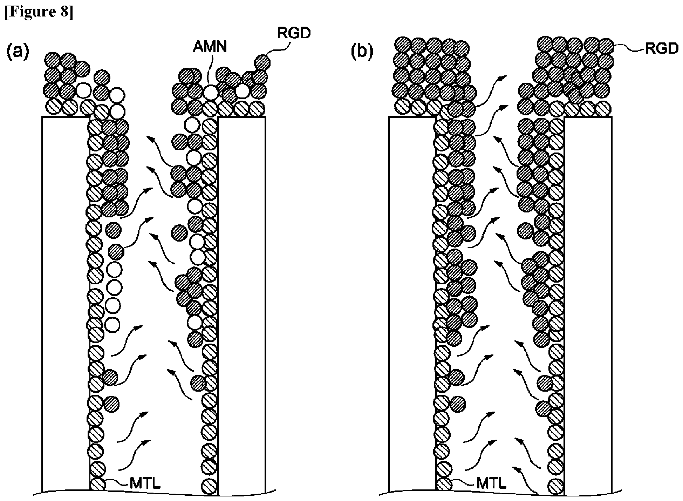

As an example of the embodiments described above, a hafnium oxide film (HfO film) is formed on a patterned wafer (that is, the wafer 200) with the concave structure formed on a surface thereof by using the substrate processing apparatus described above according to the process sequence shown in FIG. 5. When forming the HfO film, as the modifying agent, the source, the oxidizing agent and the inert gas, predetermined substances are appropriately selected from the group of the substances exemplified above in the embodiments described above. The process conditions for performing each step of the example of the embodiments are set to be predetermined conditions within a range of the process conditions for each step shown in the embodiments described above. Referring to FIG. 8(a), a schematic structure illustrating a partial formation of a film (that is, a hafnium (Hf) layer in the present example) near the concave structure and an adsorption of a ligand and an inhibitor (the NH- group from the $NH_3$ in the present example) is shown. The structure illustrates the adsorption after performing a step of supplying the source gas and a step of supplying the $NH_3$ after supplying the source gas in a method of manufacturing the HfO film. In FIG. 8(a), a symbol "AMN" represents the NH- group derived from the $NH_3$, a symbol "RGD" represents the ligand and a symbol "MTL" represents the first element of the source (for example, a hafnium atom). In a supply of the $NH_3$ of a subsequent pulse of the time division flow, it is possible to supply the $NH_3$ to the location where the NH- group has not yet been adsorbed (for example, the wafer 200 and the first layer being formed), and it is also possible to uniformly form the NH- termination near the opening of the concave structure of the wafer 200.

As a comparative example, a hafnium oxide film (HfO film) is formed on a patterned wafer (that is, the wafer 200) with the concave structure formed on a surface thereof by using the substrate processing apparatus described above according to a process sequence substantially the same as the process sequence shown in FIG. 5 except that the step A is omitted. When forming HfO film of the comparative example, as the modifying agent, the source, the oxidizing agent and the inert gas, the same substances as those used in the example of the embodiments are selected. The process conditions for performing each step of the comparative example are set to be predetermined conditions within a range of the process conditions for each step shown in the example of the embodiments. Referring to FIG. 8B, a schematic structure illustrating a partial formation of a film (that is, a hafnium (Hf) layer in the comparative example) near the concave structure and an adsorption of a ligand is shown. The structure illustrates the adsorption after performing a step of supplying the source gas in a method of manufacturing the HfO film according to the comparative example. Symbols shown in FIG. 8B are substantially the same as those shown in FIG. 8(a). In FIG. 8B, no NH- group derived from the $NH_3$ appears. The ligand is adsorbed near the opening of the concave structure.

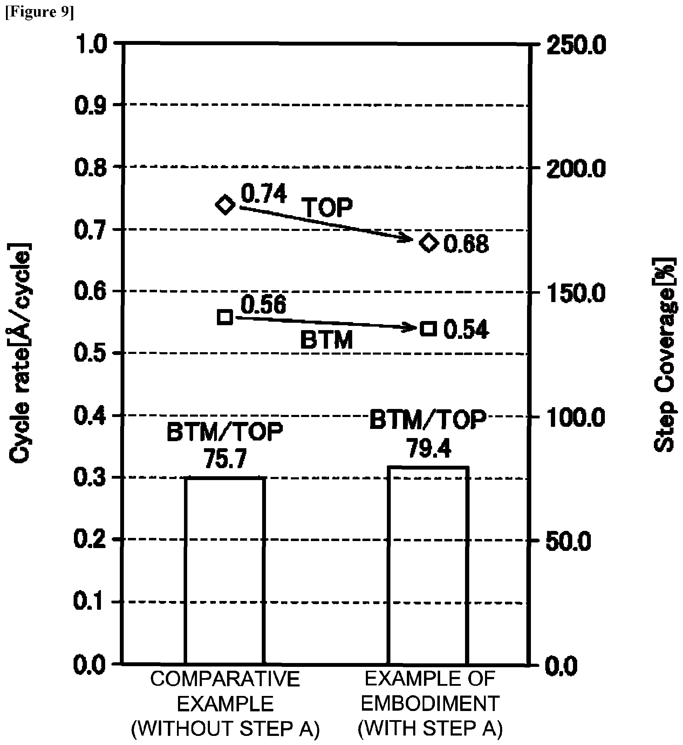

Then, a thickness of the HfO film formed in the concave structure is measured for the example of the embodiments and the comparative example. The thickness of the HfO film is measured at two locations: around the opening ("TOP" in FIG. 9) and around the bottom ("BTM" in FIG. 9) in the concave structure. Then, a cycle rate, that is, the thickness of the HfO film formed per cycle [Å / cycle] is calculated at each measurement location. Further, as an index indicating a quality of the step coverage, a value ("Step Coverage [%]" shown in FIG. 9) obtained by (the cycle rate at "BTM") / (the cycle rate at "TOP") × 100 (%) is calculated.

The results are shown in FIG. 9. In FIG. 9, a left vertical axis indicates the "Cycle rate [Å / cycle]", and a right vertical axis indicates the "Step Coverage [%]". A horizontal axis of FIG. 9 indicates the comparative example and the example of the embodiments in this order. In FIG. 9, a symbol "◇" mark indicates the cycle rate at "TOP", a symbol "□''indicates the cycle rate at "BTM", and the column graph indicates the "Step Coverage (%)".

As shown in FIG. 9, it can be seen that the "Step Coverage [%]" is improved in the example of the embodiments as a result of the cycle rate in the "TOP" being appropriately suppressed compared to the comparative example. As explained in the embodiments described above, it is considered that, by performing the step A at a predetermined timing to form the adsorption layer, the adsorption layer inhibits the adsorption of the ligand and prevents (suppresses) the by-product from entering into the HfO film.

The invention may be summarized as follows: To suppress an adhesion of a by-product generated by a reaction, there is provided a technique that includes: forming a film on a substrate by performing a cycle a predetermined number of times, wherein the cycle includes: (a) supplying a first gas containing a NH- group to the substrate; (b) supplying a source gas to the substrate; and (c) supplying a reactive gas to the substrate, wherein (a), (b) and (c) are sequentially performed in this order in the cycle, and the film contains an element contained in the source gas and an element contained in the reactive gas.

The embodiments and modified examples described above may be appropriately combined. The process sequences and the process conditions of each combination thereof may be substantially the same as those of the embodiments described above or the modified examples described above.

**[Description of Reference Numerals]**

200: wafer (substrate)

**Claims**

1. A substrate processing method comprising

    forming a film on a substrate by performing a cycle a predetermined number of times,
    wherein the cycle comprises:

        (a) supplying a first gas containing a NH- group to the substrate;
        (b) supplying a source gas to the substrate; and
        (c) supplying a reactive gas to the substrate,

    wherein (a), (b) and (c) are sequentially performed in this order in the cycle, and the film contains an element contained in the source gas and an element contained in the reactive gas.

2. The substrate processing method of claim 1, wherein the source gas comprises a gas containing an amino group.

3. The substrate processing method of claim 1 and/or 2, wherein the source gas further comprises an organic ligand.

4. The substrate processing method of any one or more of claims 1 to 3, wherein the film is free of an element contained in the first gas.

5. The substrate processing method of any one or more of claims 1 to 4, wherein the first gas is free of an organic ligand.

6. The substrate processing method of any one or more of claims 1 to 5, wherein a second gas containing an organic ligand and the NH- group is further supplied in (a).

7. The substrate processing method of any one or more of claims 1 to 6, wherein the first gas is supplied in (a) after the second gas is supplied, or

    wherein the second gas is supplied in (a) after the first gas is supplied, or
    wherein a period during which the first gas is supplied and a period during which the second gas is supplied overlap with each other in (a).

8. The substrate processing method of any one or more of claims 1 to 7, wherein a gas containing the NH- group is supplied a plurality number of times in (a).

9. The substrate processing method of any one or more of claims 1 to 8, wherein the first gas is supplied in (a) in an undecomposed state.

10. The substrate processing method of any one or more of claims 1 to 9, wherein a pressure when performing (a) is set to be higher than a pressure when performing (b).

11. The substrate processing method of any one or more of claims 1 to 10, wherein a supply amount of the first gas is set to be smaller than a supply amount of the source gas.

12. The substrate processing method of any one or more of claims 1 to 11, wherein a supply amount of the first gas is set to be smaller than a supply amount of the reactive gas.

13. A method of manufacturing a semiconductor device, comprising the substrate processing method of any one or more of claims 1 to 12.

14. A program that causes a substrate processing apparatus, by a computer, to perform:

   forming a film on a substrate by performing a cycle a predetermined number of times,
   wherein the cycle comprises:

      (a) supplying a first gas containing a NH- group to the substrate;
      (b) supplying a source gas to the substrate; and
      (c) supplying a reactive gas to the substrate,

   wherein (a), (b) and (c) are sequentially performed in this order in the cycle, and the film contains an element contained in the source gas and an element contained in the reactive gas.

15. A substrate processing apparatus comprising:

   a first gas supplier configured to supply a first gas containing a NH- group to a substrate;
   a second gas supplier configured to supply a source gas to the substrate;
   a third gas supplier configured to supply a reactive gas to the substrate; and
   a controller configured to be capable of controlling the first gas supplier, the second first gas supplier and the third first gas supplier to perform:

      forming a film on the substrate by performing a cycle a predetermined number of times,
      wherein the cycle comprises:

         (a) supplying the first gas containing the NH- group to the substrate;
         (b) supplying the source gas to the substrate; and
         (c) supplying the reactive gas to the substrate,

      wherein (a), (b) and (c) are sequentially performed in this order in the cycle, and the film contains an element contained in the source gas and an element contained in the reactive gas.

[Figure 1]

(a)

(b)

[Figure 2]

[Figure 3]

[Figure 4]

```
┌─────────────────────────────────┐
│   WAFER CHARGING STEP AND        │
│      BOAT LOADING STEP           │
└─────────────────────────────────┘
                │
                ▼
┌─────────────────────────────────┐
│  PRESSURE ADJUSTING STEP AND     │
│  TEMPERATURE ADJUSTING STEP      │
└─────────────────────────────────┘
                │
                ▼
┌─────────────────────────────────┐
│       FILM FORMING STEP          │
└─────────────────────────────────┘
                │
                ▼
┌─────────────────────────────────┐
│    AFTER-PURGE STEP AND          │
│  RETURNING TO ATMOSPHERIC        │
│       PRESSURE STEP              │
└─────────────────────────────────┘
                │
                ▼
┌─────────────────────────────────┐
│   BOAT UNLOADING STEP AND        │
│    WAFER DISCHARGING STEP        │
└─────────────────────────────────┘
```

[Figure 5]

[Figure 6]

(a)

(b)

(c)

(d)

(e)

(f)

[Figure 7]

(a)

SECOND
MODIFYING GAS

FIRST
MODIFYING GAS

TIME

(b)

SECOND
MODIFYING GAS

FIRST
MODIFYING GAS

TIME

(c)

SECOND
MODIFYING GAS

FIRST
MODIFYING GAS

TIME

(d)

SECOND
MODIFYING GAS

FIRST
MODIFYING GAS

TIME

(e)

SECOND
MODIFYING GAS

FIRST
MODIFYING GAS

TIME

[Figure 8]

[Figure 9]

# EUROPEAN SEARCH REPORT

**Application Number**

EP 24 18 5547

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/098746 A1 (NAGATOMI YOSHIMASA [JP] ET AL) 30 March 2023 (2023-03-30) | 1-5,8,9, 11-15 | INV.<br>C23C16/02 |
| Y | * page 1, paragraphs 4,5 - page 4, paragraph 43-46 *<br>* page 5, paragraphs 54,58,60 - page 6, paragraphs 72,76 *<br>* page 7, paragraph 96 - page 8, paragraph 100 *<br>* page 9, paragraph 119; claims 1,2,17 * | 6,7 | C23C16/04<br>C23C16/32<br>C23C16/34<br>C23C16/40<br>C23C16/455<br>C23C16/52<br>H01L21/02 |
| X | US 10 770 287 B2 (KOKUSAI ELECTRIC CORP [JP]) 8 September 2020 (2020-09-08)<br>* column 6, line 60 - column 8, line 21; claim 1 * | 1,5,8-15 | |
| Y | US 2021/305043 A1 (NAKATANI KIMIHIKO [JP] ET AL) 30 September 2021 (2021-09-30)<br>* page 1, paragraphs 7,8 - page 2, paragraph 23-25 *<br>* page 3, paragraph 26 - page 4, paragraph 42-44 *<br>* page 10, paragraph 135 * | 6,7 | |
| A | US 2023/070312 A1 (CHO EUNHYOUNG [KR] ET AL) 9 March 2023 (2023-03-09)<br>* the whole document * | 1-15 | **TECHNICAL FIELDS SEARCHED (IPC)**<br><br>C23C<br>H01L |
| A | US 2022/230870 A1 (HASHIMOTO YOSHITOMO [JP] ET AL) 21 July 2022 (2022-07-21)<br>* the whole document * | 1-15 | |
| A | US 2016/024649 A1 (SAITO TATSUYUKI [JP] ET AL) 28 January 2016 (2016-01-28)<br>* the whole document * | 1-15 | |

The present search report has been drawn up for all claims

| Place of search | Date of completion of the search | Examiner |
|---|---|---|
| The Hague | 19 November 2024 | Boussard, Nadège |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

# EP 4 488 405 A1

## ANNEX TO THE EUROPEAN SEARCH REPORT
## ON EUROPEAN PATENT APPLICATION NO.

EP 24 18 5547

This annex lists the patent family members relating to the patent documents cited in the above-mentioned European search report.
The members are as contained in the European Patent Office EDP file on
The European Patent Office is in no way liable for these particulars which are merely given for the purpose of information.

19-11-2024

| Patent document cited in search report | Publication date | Patent family member(s) | Publication date |
|---|---|---|---|
| US 2023098746 A1 | 30-03-2023 | CN 115863141 A | 28-03-2023 |
| | | EP 4156230 A1 | 29-03-2023 |
| | | JP 7385636 B2 | 22-11-2023 |
| | | JP 2023046964 A | 05-04-2023 |
| | | JP 2024016232 A | 06-02-2024 |
| | | KR 20230043724 A | 31-03-2023 |
| | | TW 202315002 A | 01-04-2023 |
| | | US 2023098746 A1 | 30-03-2023 |
| US 10770287 B2 | 08-09-2020 | CN 110205606 A | 06-09-2019 |
| | | CN 113846311 A | 28-12-2021 |
| | | JP 6789257 B2 | 25-11-2020 |
| | | JP 2019149516 A | 05-09-2019 |
| | | KR 20190103958 A | 05-09-2019 |
| | | KR 20210030326 A | 17-03-2021 |
| | | KR 20210114913 A | 24-09-2021 |
| | | SG 10201901678W A | 27-09-2019 |
| | | TW 201945574 A | 01-12-2019 |
| | | TW 202126841 A | 16-07-2021 |
| | | US 2019267230 A1 | 29-08-2019 |
| | | US 2020373151 A1 | 26-11-2020 |
| | | US 2021296110 A1 | 23-09-2021 |
| | | US 2023253202 A1 | 10-08-2023 |
| US 2021305043 A1 | 30-09-2021 | CN 113451111 A | 28-09-2021 |
| | | JP 7254044 B2 | 07-04-2023 |
| | | JP 2021158165 A | 07-10-2021 |
| | | KR 20210119890 A | 06-10-2021 |
| | | SG 10202102589W A | 28-10-2021 |
| | | TW 202205437 A | 01-02-2022 |
| | | US 2021305043 A1 | 30-09-2021 |
| US 2023070312 A1 | 09-03-2023 | NONE | |
| US 2022230870 A1 | 21-07-2022 | CN 114807899 A | 29-07-2022 |
| | | JP 7303226 B2 | 04-07-2023 |
| | | JP 2022110465 A | 29-07-2022 |
| | | KR 20220104640 A | 26-07-2022 |
| | | TW 202230514 A | 01-08-2022 |
| | | TW 202347502 A | 01-12-2023 |
| | | US 2022230870 A1 | 21-07-2022 |
| US 2016024649 A1 | 28-01-2016 | JP 5692842 B2 | 01-04-2015 |
| | | JP 2011252221 A | 15-12-2011 |
| | | US 2013095668 A1 | 18-04-2013 |
| | | US 2015214045 A1 | 30-07-2015 |

EPO FORM P0459

For more details about this annex : see Official Journal of the European Patent Office, No. 12/82

page 1 of 2

## ANNEX TO THE EUROPEAN SEARCH REPORT
## ON EUROPEAN PATENT APPLICATION NO.

EP 24 18 5547

This annex lists the patent family members relating to the patent documents cited in the above-mentioned European search report.
The members are as contained in the European Patent Office EDP file on
The European Patent Office is in no way liable for these particulars which are merely given for the purpose of information.

19-11-2024

| Patent document cited in search report | Publication date | Patent family member(s) | | Publication date |
|---|---|---|---|---|
| | | US | 2016024649 A1 | 28-01-2016 |
| | | WO | 2011152352 A1 | 08-12-2011 |

EPO FORM P0459

For more details about this annex : see Official Journal of the European Patent Office, No. 12/82

page 2 of 2

**EP 4 488 405 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2008124184 A